# EUROPEAN PATENT SPECIFICATION

(11) **EP 4 203 645 B1**
(45) Date of publication and mention of the grant of the patent: **16.09.2026**
(21) Application number: 22203340.9
(22) Date of filing: 24.10.2022
(51) Int. Cl.: H10K 50/11, H10K 50/19, H10K 85/30, H10K 85/60

(54) **ORGANIC LIGHT EMITTING DIODE AND ORGANIC LIGHT EMITTING DISPLAY DEVICE INCLUDING THE SAME**
ORGANISCHE LICHTEMITTIERENDE DIODE UND ORGANISCHE LICHTEMITTIERENDE ANZEIGEVORRICHTUNG DAMIT
DIODE ÉLECTROLUMINESCENTE ORGANIQUE ET DISPOSITIF D'AFFICHAGE ÉLECTROLUMINESCENT ORGANIQUE LA COMPRENANT

(30) Priority: 27.12.2021 KR 20210188257
(43) Date of publication of application: 28.06.2023
(73) Proprietor: LG Display Co., Ltd., SEOUL, 07336 (KR)
(72) Inventor: AHN, Han-Jin, 10845 Gyeonggi-do (KR); KIM, Gyeong-Woo, 10845 Gyeonggi-do (KR); JANG, Ji-Seon, 10845 Gyeonggi-do (KR); IM, Joon-Beom, 10845 Gyeonggi-do (KR); KIM, Jun-Yun, 10845 Gyeonggi-do (KR)
(74) Representative: Heller, Benjamin Henry

(56) References cited:
- US-A1- 2021 005 825
- B.M. LEE ET AL: "Study on hybrid blue organic light emitting diodes with step controlled doping profiles in phosphorescent emitting layer", OPTICAL MATERIALS, ELSEVIER SCIENCE PUBLISHERS B.V. AMSTERDAM, NL, vol. 86, 1 November 2018 (2018-11-01), pages 498 - 504, XP085552835, ISSN: 0925-3467, DOI: 10.1016/J.OPTMAT.2018.09.039
- BARANOFF ETIENNE ET AL: "FIrpic: archetypal blue phosphorescent emitter for electroluminescence", DALTON TRANSACTIONS, vol. 44, no. 18, 4 November 2014 (2014-11-04), Cambridge, pages 8318 - 8329, XP093065632, ISSN: 1477-9226, DOI: 10.1039/C4DT02991G
- TYLER FLEETHAM ET AL: "Efficient “Pure” Blue OLEDs Employing Tetradentate Pt Complexes with a Narrow Spectral Bandwidth", ADVANCED MATERIALS, vol. 26, no. 41, 10 September 2014 (2014-09-10), DE, pages 7116 - 7121, XP055362013, ISSN: 0935-9648, DOI: 10.1002/adma.201401759
- BAEK H I ET AL: "Optimization of white organic light emitting diodes based on emitting layer charge carrier conduction properties; Optimization of white OLEDs", JOURNAL OF PHYSICS D: APPLIED PHYSICS, INSTITUTE OF PHYSICS PUBLISHING, BRISTOL, GB, vol. 41, no. 10, 21 May 2008 (2008-05-21), pages 105101, XP020133230, ISSN: 0022-3727

## Description

### CROSS-REFERENCE TO RELATED APPLICATIONS

The present application claims the benefit of Korean Patent Application No. 10-2021-0188257 filed in the Republic of Korea on December 27, 2021.

### BACKGROUND

### TECHNICAL FIELD

The present disclosure relates to an organic light emitting diode, and more particularly, to an organic light emitting diode having high display performance and an organic light emitting device including the organic light emitting diode.

### DISCUSSION OF THE RELATED ART

Requirement for flat panel display devices having small occupied area is increased. Among the flat panel display devices, a technology of an organic light emitting display device, which includes an organic light emitting diode (OLED) and may be called to as an organic electroluminescent device, is rapidly developed.

The OLED emits light by injecting electrons from a cathode as an electron injection electrode and holes from an anode as a hole injection electrode into an emitting material layer, combining the electrons with the holes, generating an exciton, and transforming the exciton from an excited state to a ground state.

However, the related art OLED has a limitation in the emitting property, e.g., the driving voltage, the luminance, the color purity and lifespan. In particular, there is a big limitation in the blue OLED.

B.M. Lee et al: "Study on hybrid blue organic light emitting diodes with step controlled doping profiles in phosphorescent emitting layer", Optical Materials, Elsevier Science Publishers B.V. Amsterdam, NL, vol. 86, 1 November 2018, pages 498-504 describes blue OLEDs consisting of fluorescent and phosphorescent emitters whose phosphorescent emitting layers have three step-controlled doping profiles of 0, 4 and 8%. The different doping profiles determined the characteristics of electroluminescent and fluorescent intensity variation under various voltages.

Baranoff Etienne et al: "Flrpic: archetypal blue phosphorescent emitter for electroluminescence", Dalton Transactions, vol. 44, no. 18, 4 November 2014, pages 8318-8329, Cambridge describes the synthesis, structural characterisations, and key properties of Flrpic, surveys the theoretical studies and summarises a series of selected monochromatic electroluminescent devices using Flrpic as the emitting dopant.

Tyler Fleetham et al: "Efficient "Pure" Blue OLEDs Employing Tetradentate Pt Complexes with a Narrow Spectral Bandwidth", Advanced Materials, vol. 26, no. 41, 10 September 2014, pages 7116-7121, DE describes deep-blue-emitting tetradentate platinum complexes with a narrow spectral bandwidth, which demonstrate CIEx ≈ 0.15 and CIEy < 0.1. An OLED with 24.8% peak external quantum efficiency and CIE coordinates of (0.147, 0.079) is fabricated using PtON7-dtb.

US 2021/005825 A1 describes an organic electroluminescence device comprising a cathode, an anode and an organic layer disposed between the cathode and the anode, wherein the organic layer comprises a fluorescent emitting layer and the fluorescent emitting layer comprises at least one first compound, a second compound, and a dopant materia.

Baek H I et al: "Optimization of white organic light emitting diodes based on emitting layer charge carrier conduction properties; Optimization of white OLEDs", Journal of Physics D: Applied Physics, Institute of Physics Publishing, Bristol, GB, vol. 41, no. 10, 21 May 2008, page 105101 describes white OLEDs with multi-emitting layer (EML) structures in which 4,4'-N,N'-dicarbazole-biphenyl (CBP) layers doped with the phosphorescent dopants fac-tris(2-phenylpyridine) iridium (Ir(ppy)₃) and bis(2-(2'-benzo[4,5-a]thienyl)pyridinato-N,C3')iridium(acetylacetonate) (btp₂Ir(acac)) and the fluorescent dopant 4,4'-bis[2-{4-(N,N-diphenylamino) phenyl}vinyl]biphenyl (DPAVBi) were used as green (G), red (R) and blue (B) EMLs, respectively.

### SUMMARY

Accordingly, embodiments of the present disclosure are directed to an OLED and an organic light emitting device that substantially obviate one or more of the problems associated with the limitations and disadvantages of the related art.

An object of the present disclosure is to provide an OLED and an organic light emitting device having high display performance.

Additional features and aspects will be set forth in the description that follows, and in part will be apparent from the description, or may be learned by practice of the present disclosure concepts provided herein. Other features and aspects of the present disclosure concepts may be realized and attained by the structure particularly pointed out in the written description, or derivable therefrom, and the claims hereof as well as the appended drawings.

To achieve these and other advantages in accordance with the purpose of the embodiments of the present invention there is provided an organic light emitting diode including a reflective electrode; a transparent electrode facing the reflective electrode; a first blue emitting part including a first emitting material layer anc positioned between the reflective electrode and the transparent electrode, the first blue emitting material layer being a fluorescent emitting layer comprising a fourth compound as a fluorescent dopant; and a second blue emitting part including a second emitting material layer and positioned between the first emitting part and the transparent electrode, the second blue emitting material layer being a phosphorescent emitting layer comprising a first compound as a phosphorescent dopant, wherein a ratio of a second emission peak intensity of the first phosphorescent dopant compound in the second blue emitting material layer to the first phosphorescent dopant compound in the first emission peak intensity of the second emitting material layer is 0.5 or less.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the present disclosure and are incorporated in and constitute a part of this application, illustrate embodiments of the present disclosure and together with the description serve to explain principles of the present disclosure.
FIG. 1 is a schematic circuit diagram of an organic light emitting display device of the present disclosure.
FIG. 2 is a schematic cross-sectional view of an organic light emitting display device according to a first embodiment of the present disclosure.
FIG. 3 is a schematic cross-sectional view of an OLED according to a second embodiment of the present disclosure.
FIG. 4 is a schematic cross-sectional view of an organic light emitting display device according to a third embodiment of the present disclosure.
FIG. 5 is a schematic cross-sectional view of an organic light emitting display device according to a fourth embodiment of the present disclosure.
FIG. 6 is a schematic cross-sectional view of an OLED according to a fifth embodiment of the present disclosure.
FIGs. 7A and 7B are a PL spectrum of phosphorescent compound used in the OLED of Comparative Examples.
FIGs. 8A and 8B are a PL spectrum of phosphorescent compound used in the OLED of Examples of the present disclosure.
FIG. 9 is a PL spectrum of a fluorescent compound used in the OLED of Examples of the present disclosure.

### DETAILED DESCRIPTION

Reference will now be made in detail to some of the examples and preferred embodiments, which are illustrated in the accompanying drawings.

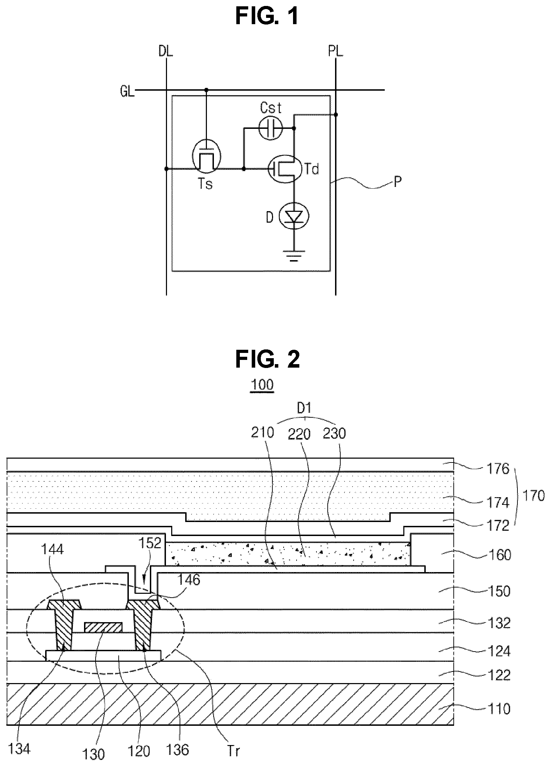

FIG. 1 is a schematic circuit diagram of an organic light emitting display device of the present disclosure.

As shown in FIG. 1, an organic light emitting display device includes a gate line GL, a data line DL, a power line PL, a switching thin film transistor TFT Ts, a driving TFT Td, a storage capacitor Cst, and an OLED D. The gate line GL and the data line DL cross each other to define a pixel region P. The pixel region may include a red pixel region, a green pixel region and a blue pixel region.

The switching TFT Ts is connected to the gate line GL and the data line DL, and the driving TFT Td and the storage capacitor Cst are connected to the switching TFT Ts and the power line PL. The OLED D is connected to the driving TFT Td.

In the organic light emitting display device, when the switching TFT Ts is turned on by a gate signal applied through the gate line GL, a data signal from the data line DL is applied to the gate electrode of the driving TFT Td and an electrode of the storage capacitor Cst.

When the driving TFT Td is turned on by the data signal, an electric current is supplied to the OLED D from the power line PL. As a result, the OLED D emits light. In this case, when the driving TFT Td is turned on, a level of an electric current applied from the power line PL to the OLED D is determined such that the OLED D can produce a gray scale.

The storage capacitor Cst serves to maintain the voltage of the gate electrode of the driving TFT Td when the switching TFT Ts is turned off. Accordingly, even if the switching TFT Ts is turned off, a level of an electric current applied from the power line PL to the OLED D is maintained to next frame.

As a result, the organic light emitting display device displays a desired image.

FIG. 2 is a schematic cross-sectional view of an organic light emitting display device according to a first embodiment of the present disclosure.

As shown in FIG. 2, the organic light emitting display device 100 includes a substrate 110, a TFT Tr on or over the substrate 110, a planarization layer 150 covering the TFT Tr and an OLED D on the planarization layer 150 and connected to the TFT Tr. A red pixel region, a green pixel region and a blue pixel region may be defined on the substrate 110.

The substrate 110 may be a glass substrate or a flexible substrate. For example, the flexible substrate may be one of a polyimide (PI) substrate, a polyethersulfone (PES) substrate, a polyethylenenaphthalate (PEN) substrate, a polyethylene terephthalate (PET) substrate and a polycarbonate (PC) substrate.

A buffer layer 122 is formed on the substrate, and the TFT Tr is formed on the buffer layer 122. The buffer layer 122 may be omitted. For example, the buffer layer 122 may be formed of an inorganic insulating material, e.g., silicon oxide or silicon nitride.

A semiconductor layer 120 is formed on the buffer layer 122. The semiconductor layer 120 may include an oxide semiconductor material or polycrystalline silicon.

When the semiconductor layer 120 includes the oxide semiconductor material, a light-shielding pattern (not shown) may be formed under the semiconductor layer 120. The light to the semiconductor layer 120 is shielded or blocked by the light-shielding pattern such that thermal degradation of the semiconductor layer 120 can be prevented. On the other hand, when the semiconductor layer 120 includes polycrystalline silicon, impurities may be doped into both sides of the semiconductor layer 120.

A gate insulating layer 124 is formed on the semiconductor layer 120. The gate insulating layer 124 may be formed of an inorganic insulating material such as silicon oxide or silicon nitride.

A gate electrode 130, which is formed of a conductive material, e.g., metal, is formed on the gate insulating layer 124 to correspond to a center of the semiconductor layer 120. In FIG. 2, the gate insulating layer 124 is formed on an entire surface of the substrate 110. Alternatively, the gate insulating layer 124 may be patterned to have the same shape as the gate electrode 130.

An interlayer insulating layer 132 is formed on the gate electrode 130 and over an entire surface of the substrate 110. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 120. The first and second contact holes 134 and 136 are positioned at both sides of the gate electrode 130 to be spaced apart from the gate electrode 130.

The first and second contact holes 134 and 136 are formed through the gate insulating layer 124. Alternatively, when the gate insulating layer 124 is patterned to have the same shape as the gate electrode 130, the first and second contact holes 134 and 136 is formed only through the interlayer insulating layer 132.

A source electrode 144 and a drain electrode 146, which are formed of a conductive material, e.g., metal, are formed on the interlayer insulating layer 132.

The source electrode 144 and the drain electrode 146 are spaced apart from each other with respect to the gate electrode 130 and respectively contact both sides of the semiconductor layer 120 through the first and second contact holes 134 and 136.

The semiconductor layer 120, the gate electrode 130, the source electrode 144 and the drain electrode 146 constitute the TFT Tr. The TFT Tr serves as a driving element. Namely, the TFT Tr is the driving TFT Td (of FIG. 1).

In the TFT Tr, the gate electrode 130, the source electrode 144, and the drain electrode 146 are positioned over the semiconductor layer 120. Namely, the TFT Tr has a coplanar structure.

Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 150 is formed on an entire surface of the substrate 110 to cover the source and drain electrodes 144 and 146. The planarization layer 150 provides a flat top surface and has a drain contact hole 152 exposing the drain electrode 146 of the TFT Tr.

The OLED D is disposed on the planarization layer 150 and includes a first electrode 210, which is connected to the drain electrode 146 of the TFT Tr, an organic light emitting layer 220 and a second electrode 230. The organic light emitting layer 220 and the second electrode 230 are sequentially stacked on the first electrode 210. The OLED D is positioned in each of the red, green and blue pixel regions and respectively emits the red, green and blue light.

The first electrode 210 is separately formed in each pixel region. The first electrode 210 may be an anode and may include a transparent conductive oxide material layer, which may be formed of a conductive material, e.g., a transparent conductive oxide (TCO), having a relatively high work function, and a reflection layer. Namely, the first electrode 210 may be a reflective electrode.

Alternatively, the first electrode 210 may have a single-layered structure of the transparent conductive oxide material layer. Namely, the first electrode 210 may be a transparent electrode.

For example, the transparent conductive oxide material layer may be formed of one of indium-tin-oxide (ITO), indium-zinc-oxide (IZO), indium-tin-zinc-oxide (ITZO), tin oxide (SnO), zinc oxide (ZnO), indium-copper-oxide (ICO) and aluminum-zinc-oxide (Al:ZnO, AZO), and the reflection layer may be formed of one of silver (Ag), an alloy of Ag and one of palladium (Pd), copper (Cu), indium (In) and neodymium (Nd), and aluminum-palladium-copper (APC) alloy. For example, the first electrode 210 may have a structure of ITO/Ag/ITO or ITO/APC/ITO.

In addition, a bank layer 160 is formed on the planarization layer 150 to cover an edge of the first electrode 210. Namely, the bank layer 160 is positioned at a boundary of the pixel region and exposes a center of the first electrode 210 in the pixel region.

The organic light emitting layer 220 as an emitting unit is formed on the first electrode 210. In the OLED D1 in the blue pixel region, the organic light emitting layer 220 includes a first emitting part including a first blue emitting material layer (EML) and a second emitting part including a second blue EML. Namely, the organic light emitting layer 220 has a multi-stack structure such that the OLED D has a tandem structure.

Each of the first and second emitting parts may further include at least one of a hole injection layer (HIL), a hole transporting layer (HTL), an electron blocking layer (EBL), a hole blocking layer (HBL), an electron transporting layer (ETL) and an electron injection layer (EIL) to have a multi-layered structure. In addition, the organic light emitting layer may further include a charge generation layer (CGL) between the first and second emitting parts.

As explained below, in the OLED D1 in the blue pixel region, the first blue EML is a fluorescent emitting layer including a host and a fluorescent dopant, and the second blue EML is a phosphorescent emitting layer including a first host, a second host and a phosphorescent dopant. In this instance, the second blue EML being the phosphorescent emitting layer is disposed to be closer to a second electrode 230 as a transparent (semitransparent) electrode than the first blue EML being the fluorescent emitting layer, and the first and second blue EMLs meet a condition in that a ratio "I_{2nd}/I^{1st}" of a second emission peak intensity of the first compound in the second EML to a first emission peak intensity of the first compound in the second EML is 0.5 or less. As a result, the OLED D1 has advantages in the emitting efficiency and the lifespan.

Emission peak intensity may be measured at room temperature (i.e. 25°C) in an organic solvent, such as toluene. For example, a solution of the first compound in an organic solvent (such as toluene) having a concentration of about 1 x 10⁻⁵ M may be used. The emission peak intensity may be measured using a fluorescence spectrometer, such as FS-5 Fluorescence spectrometer (Edinburgh Instruments), with photoluminescence detection.

The second electrode 230 is formed over the substrate 110 where the organic light emitting layer 220 is formed. The second electrode 230 covers an entire surface of the display area and may be formed of a conductive material having a relatively low work function to serve as a cathode. For example, the second electrode 230 may be formed of aluminum (Al), magnesium (Mg), calcium (Ca), silver (Ag) or their alloy, e.g., Mg-Ag alloy (MgAg). The second electrode 230 may have a thin profile, e.g., 10 to 30nm, to be transparent (or semi-transparent).

Although not shown, the OLED D may further include a capping layer on the second electrode 230. The emitting efficiency of the OLED D may be further improved by the capping layer.

An encapsulation film (or an encapsulation layer) 170 is formed on the second electrode 230 to prevent penetration of moisture into the OLED D. The encapsulation film 170 includes a first inorganic insulating layer 172, an organic insulating layer 174 and a second inorganic insulating layer 176 sequentially stacked, but it is not limited thereto.

Although not shown, the organic light emitting display device 100 may include a color filter corresponding to the red, green and blue pixel regions. For example, the color filter may be positioned on or over the OLED D or the encapsulation film 170.

In addition, the organic light emitting display device 100 may further include a cover window (not shown) on or over the encapsulation film 170 or the color filter. In this instance, the substrate 110 and the cover window have a flexible property such that a flexible organic light emitting display device may be provided.

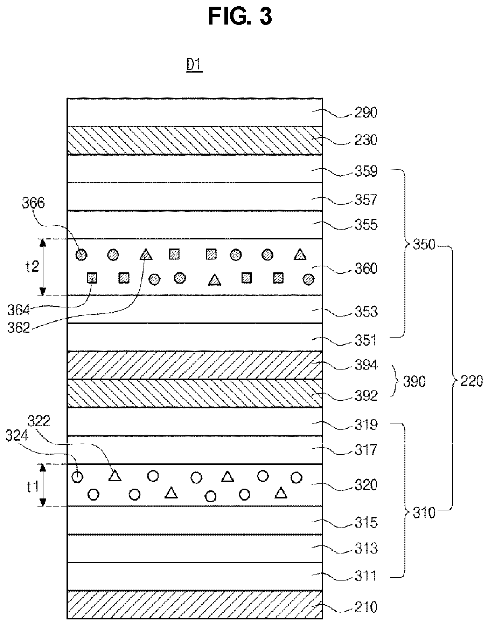

FIG. 3 is a schematic cross-sectional view of an OLED according to a second embodiment of the present disclosure.

As shown in FIG. 3, the OLED D1 includes the first electrode 210 as a reflective electrode, the second electrode 230 as a transparent electrode (or a semi-transparent electrode) facing the first electrode 210, and the organic light emitting layer 220 therebetween. The organic light emitting layer 220 includes a first emitting part 310 including a first blue EML 320 and a second emitting part 350 including a second blue EML 360. In addition, the organic light emitting layer 220 may further include a CGL 390 between the first and second emitting parts 310 and 350. Moreover, the OLED D1 may further include a capping layer 290 for enhancing (improving) an emitting efficiency.

The organic light emitting display device may include a red pixel region, a green pixel region and a blue pixel region, and the OLED D1 is positioned in the blue pixel region.

The first electrode 210 may be anode, and the second electrode 230 may be a cathode. The first electrode 210 is a reflective electrode, and the second electrode 230 is a transparent electrode (or a semi-transparent electrode). For example, the first electrode 210 may have a structure of ITO/Ag/ITO, and the second electrode 230 may be formed of MgAg or Al. In the second electrode 230 of MgAg, Mg may be doped with about 10 wt%. Namely, the first electrode 210 may have a first transmittance, and the second electrode 230 may have a second transmittance greater than the first transmittance.

The first emitting part 310 may further include at least one of a first HTL 313 positioned under the first blue EML 320 and a first ETL 319 positioned on the first blue EML 320. In addition, the first emitting part 310 may further include an HIL 311 positioned under the first HTL 313. Moreover, the first emitting part 310 may further include at least one of a first EBL 315 positioned between the first blue EML 320 and the first HTL 313 and a first HBL 317 positioned between the first blue EML 320 and the first ETL 319.

The second emitting part 350 may further include at least one of a second HTL 351 positioned under the second blue EML 360 and a second ETL 357 positioned on the second blue EML 360. In addition, the second emitting part 350 may further include an ElL 359 positioned on the second ETL 357. Moreover, the second emitting part 350 may further include at least one of a second EBL 353 positioned between the second blue EML 360 and the second HTL 351 and a second HBL 355 positioned between the second blue EML 360 and the second ETL 357.

The CGL 390 is positioned between the first and second emitting parts 310 and 350, and the first and second emitting parts 310 and 350 are connected through the CGL 390. The first emitting part 310, the CGL 390 and the second emitting part 350 are sequentially stacked on the first electrode 210. Namely, the first emitting part 310 is positioned between the first electrode 210 and the CGL 390, and the second emitting part 350 is positioned between the second electrode 230 and the CGL 390.

The CGL 390 may be a P-N junction type CGL of an N-type CGL 392 and a P-type CGL 394. The N-type CGL 392 is positioned between the first ETL 319 and the second HTL 351, and the P-type CGL 394 is positioned between the N-type CGL 392 and the second HTL 351. The N-type CGL 392 provides an electron into the first blue EML 320 of the first emitting part 310, and the P-type CGL 394 provides a hole into the second blue EML 360 of the second emitting part 350.

The second blue EML 360 being the phosphorescent emitting layer includes a first compound 362, a second compound 364 and a third compound 366. The first compound 362 is a phosphorescent emitter (dopant), the second compound 364 is a p-type host, e.g., a first host, and the third compound 366 is an n-type host, e.g., a second host.

The first compound 362 is represented by Formula 1.

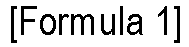

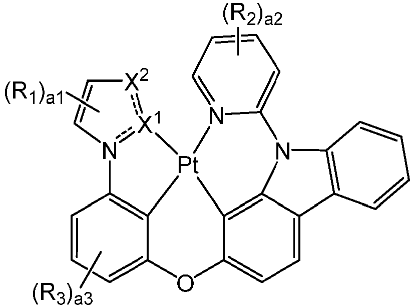

In Formula 1, each of R₁, R₂, and R₃ is independently selected from the group consisting of a substituted or unsubstituted C1 to C10 alkyl group, a substituted or unsubstituted C6 to C30 aryl group and a substituted or unsubstituted C5 to C30 heteroaryl group. a1 is an integer of 0 to 2, a2 is an integer of 0 to 4, and a3 is an integer of 0 to 4. X₁ is C or N, and X₂ is CR₄ or NR₄. R₄ is selected from the group consisting of hydrogen, a substituted or unsubstituted C1 to C10 alkyl group, a substituted or unsubstituted C6 to C30 aryl group and a substituted or unsubstituted C5 to C30 heteroaryl group.

In the present disclosure, without specific definition, a substituent of an alkyl group, an aryl group, a heteroaryl group, an arylene group, a heteroarylene group and an arylamine group may be at least one of deuterium (D), a C1 to C10 alkyl group and a C6 to C30 aryl group. A group defined herein as being "substituted or unsubstituted" is preferably unsubstituted.

A group described as "substituted or unsubstituted" may be substituted with one or more groups defined herein (as valency allows).

In the present disclosure, the C6 to C30 aryl group (or C6 to C30 arylene group) may be selected from the group consisting of phenyl, biphenyl, terphenyl, naphthyl, anthracenyl, pentanenyl, indenyl, indenoindenyl, heptalenyl, biphenylenyl, indacenyl, phenanthrenyl, benzophenanthrenyl, dibenzophenanthrenyl, azulenyl, pyrenyl, fluoranthenyl, triphenylenyl, chrysenyl, tetraphenyl, tetrasenyl, picenyl, pentaphenyl, pentacenyl, fluorenyl, indenofluorenyl and spiro-fluorenyl. Preferably an aryl group is phenyl.

In the present disclosure, the C5 to C30 heteroaryl group may be selected from the group consisting of pyrrolyl, pyridinyl, pyrimidinyl, pyrazinyl, pyridazinyl, triazinyl, tetrazinyl, imidazolyl, pyrazolyl, indolyl, isoindolyl, indazolyl, indolizinyl, pyrrolizinyl, carbazolyl, benzocarbazolyl, dibenzocarbazolyl, indolocarbazolyl, indenocarbazolyl, benzofurocarbazolyl, benzothienocarbazolyl, quinolinyl, isoquinolinyl, phthalazinyl, quinoxalinyl, cinnolinyl, quinazolinyl, quinozolinyl, quinolinyl, purinyl, phthalazinyl, quinoxalinyl, benzoquinolinyl, benzoisoquinolinyl, benzoquinazolinyl, benzoquinoxalinyl, acridinyl, phenanthrolinyl, perimidinyl, phenanthridinyl, pteridinyl, cinnolinyl, naphtharidinyl, furanyl, oxazinyl, oxazolyl, oxadiazolyl, triazolyl, dioxynyl, benzofuranyl, dibenzofuranyl, thiopyranyl, xanthenyl, chromanyl, isochromanyl, thioazinyl, thiophenyl, benzothiophenyl, dibenzothiophenyl, difuropyrazinyl, benzofurodibenzofuranyl, benzothienobenzothiophenyl, benzothienodibenzothiophenyl, benzothienobenzofuranyl, and benzothienodibenzofuranyl.

For example, in Formula 1, each of R₁, R₃ and R₄ may be selected from a substituted or unsubstituted C1 to C10 alkyl group, e.g., methyl or tert-butyl, and R₂ may be selected from a substituted or unsubstituted C1 to C10 alkyl group, e.g., tert-butyl, or a substituted or unsubstituted C5 to C30 heteroaryl group, e.g., carbazolyl. In addition, at least one of a1, a2 and a3 may be a positive integer.

In Formula 1, X₁ may be C, and X₂ may be NR₄. Namely, Formula 1 may be represented by Formula 1a.

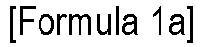

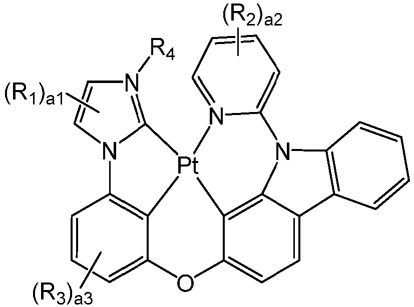

In Formula 1a, the definitions of R₁, R₂, R₃, R₄, a1, a2 and a3 are same as those in Formula 1.

Alternatively, in Formula 1, X₁ may be N, and X₂ may be CR₄. Namely, Formula 1 may be represented by Formula 1b.

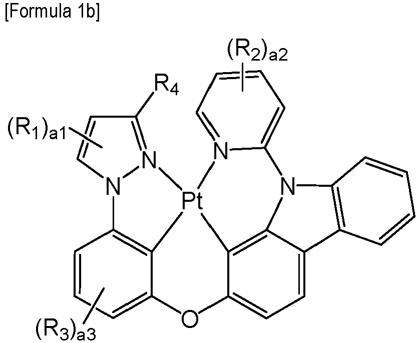

In Formula 1b, the definitions of R₁, R₂, R₃, R₄, a1, a2 and a3 are same as those in Formula 1.

For example, the first compound 362 may be one of the compounds in Formula 2.

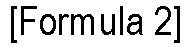

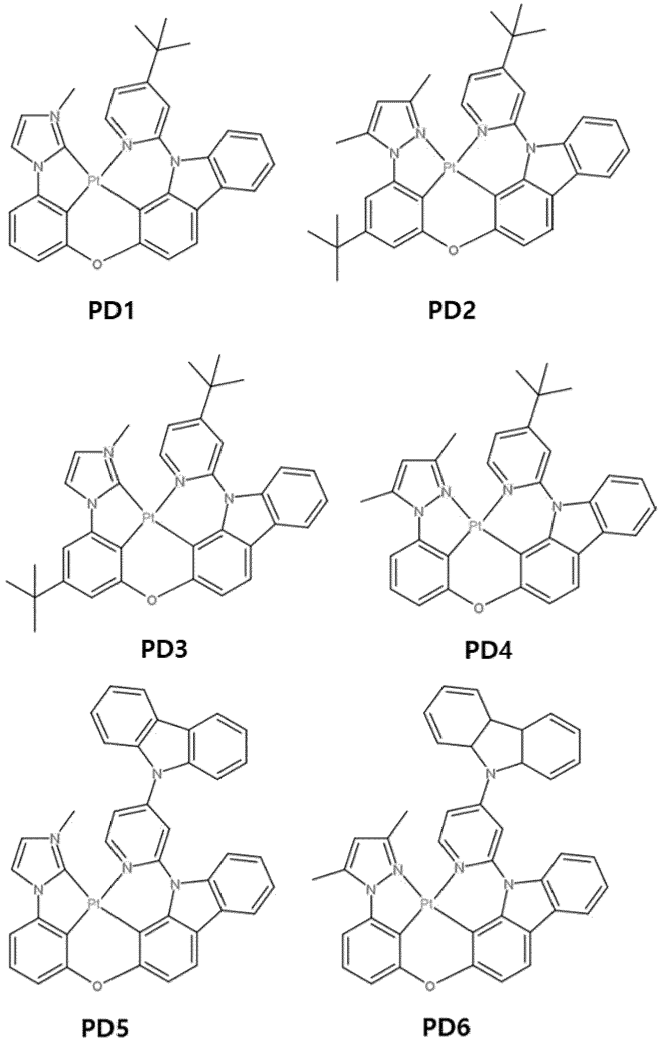

The second compound 364 is represented by Formula 3.

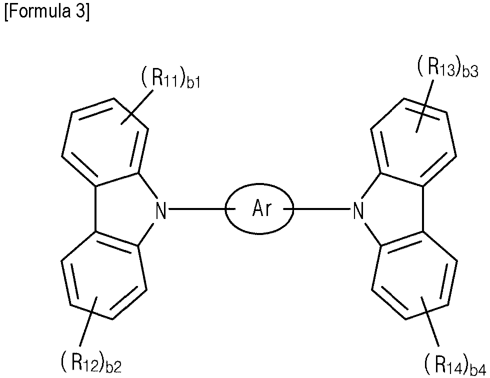

In Formula 3, Ar is selected from the group consisting of a substituted or unsubstituted C6 to C30 arylene group and a substituted or unsubstituted C5 to C30 heteroarylene group. Each of R₁₁, R₁₂, R₁₃ and R₁₄ is independently selected from the group consisting of a substituted or unsubstituted C1 to C10 alkyl group and a substituted or unsubstituted C6 to C30 aryl group, and each of b1, b2, b3 and b4 is independently an integer of 0 to 4.

For example, Ar may be one of biphenylene and phenylene.

Formula 3 may be represented by Formula 3a.

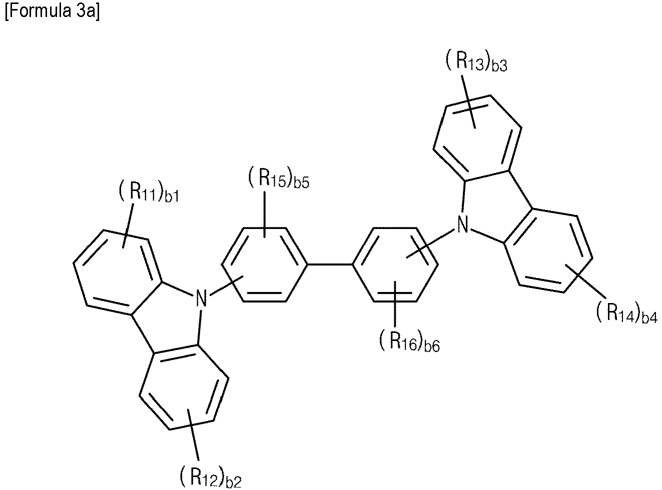

In Formula 3a, each of R15 and R16 is independently selected from the group consisting of a substituted or unsubstituted C1 to C10 alkyl group and a substituted or unsubstituted C6 to C30 aryl group, and each of b5 and b6 is independently an integer of 0 to 4. The definitions of R₁₁, R₁₂, R₁₃ R₁₄, b1, b2, b3 and b4 are same as those in Formula 3.

Alternatively, Formula 3 may be represented by Formula 3b.

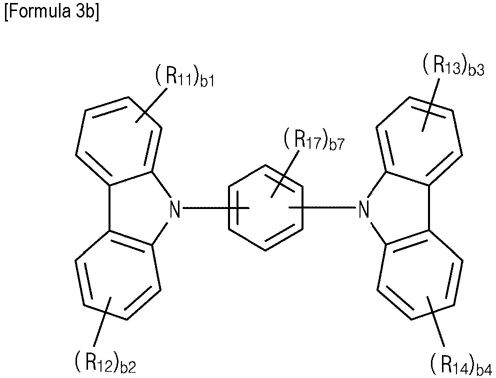

In Formula 3b, R17 is independently selected from the group consisting of a substituted or unsubstituted C1 to C10 alkyl group and a substituted or unsubstituted C6 to C30 aryl group, and b7 is independently an integer of 0 to 4. The definitions of R₁₁, R₁₂, R₁₃ R₁₄, b1, b2, b3 and b4 are same as those in Formula 3.

For example, the second compound 364 may be one of the compounds in Formula 4.

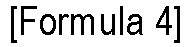

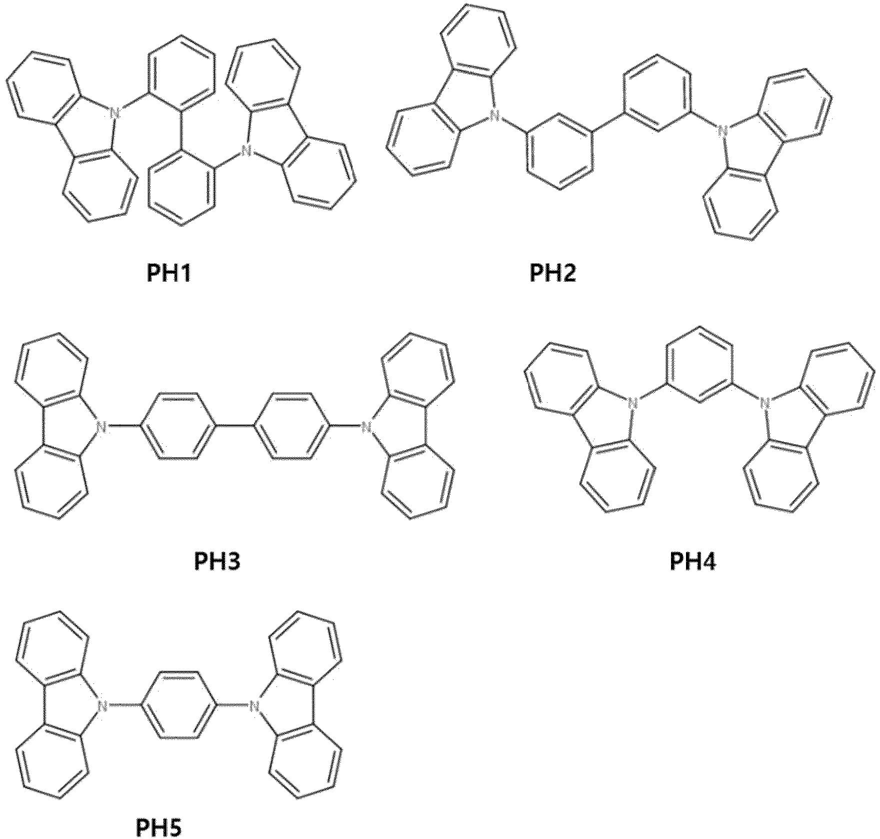

The third compound 366 is represented by Formula 5.

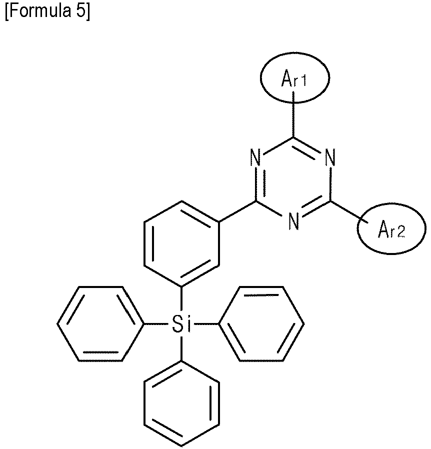

In Formula 5, each of Ar₁ and Ar₂ is independently selected from the group consisting of a substituted or unsubstituted C6 to C30 aryl group and a substituted or unsubstituted C5 to C30 heteroaryl group.

For example, each of Ar₁ and Ar₂ may be selected from the group consisting of phenyl, triphenylsilyl and carbazolyl and may be same or different.

The third compound 366 may be one of the compounds in Formula 6.

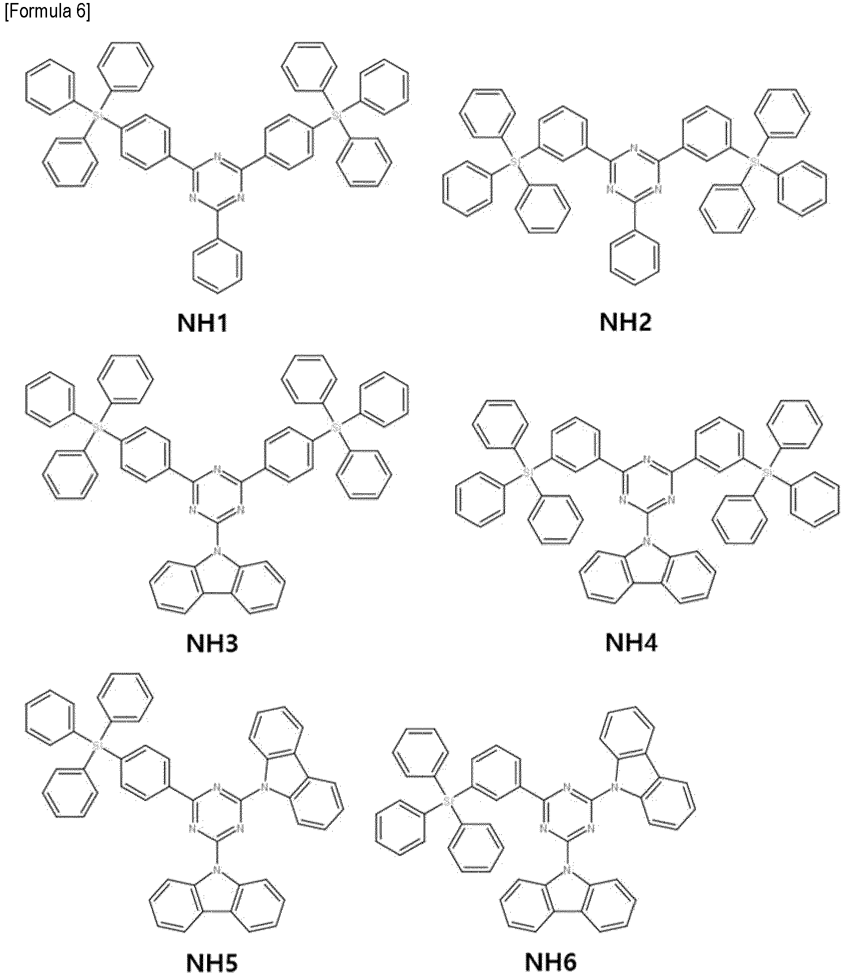

In the second blue EML 360, each of a weight % of the second compound 364 and a weight % of the third compound 366 may be greater than a weight % of the first compound 362, and the weight % of the second compound 364 and the weight % of the third compound 366 may same or different. For example, with respect to the second compound 364 or the third compound 366, the second compound 364 may have a weight % of 5 to 30.

In the second blue EML 360, a ratio "I_{2nd}/I₁ₛₜ" of the second emission peak intensity "I_{2nd}" to the first emission peak intensity "I₁ₛₜ" is 0.5 or less. Namely, in the first compound 362, the ratio of the second emission peak intensity to the first emission peak intensity is relatively smaller. For example, in the first compound 362, a ratio "I_{2nd}/I₁ₛₜ" of the second emission peak intensity "I_{2nd}" to the first emission peak intensity "I₁ₛₜ" is 0.5 or less. The first emission peak means a peak having the largest emission intensity, and the second emission peak means a peak having the second largest emission intensity.

As mentioned above, the second blue EML 360 is disposed to be closer to the second electrode 230 being the transparent electrode than the first blue EML 320, and the first compound 362 of the second blue EML 360 meets the above condition. As a result, in the OLED D1, the cavity effect is increased (intensified), and the luminance is significantly improved. Namely, the second blue EML 360 being the phosphorescent emitting layer is positioned between the first blue EML 320 being the fluorescent emitting layer and the second electrode 230 being the transparent electrode.

Alternatively, when the first electrode 210 is a transparent electrode, the second blue EML 360 being the phosphorescent emitting layer is positioned between the first blue EML 320 being the fluorescent emitting layer and the first electrode 210 being the transparent electrode.

The first blue EML 320 being the fluorescent emitting layer includes a fourth compound 322 and a fifth compound 324. The fourth compound 322 is a fluorescent emitter, and the fifth compound 324 is a host.

The fourth compound 322 is represented by Formula 7.

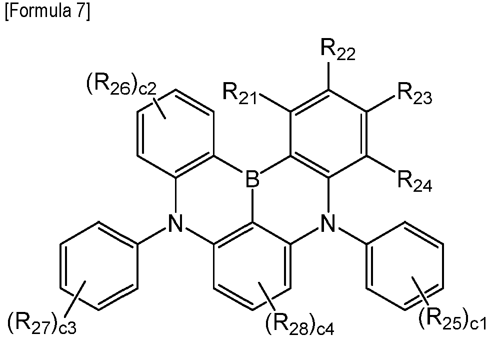

In Formula 7, each of R₂₁, R₂₂, R₂₃ and R₂₄ is independently selected from the group consisting of hydrogen, a substituted or unsubstituted C1 to C10 alkyl group, a substituted or unsubstituted C6 to C30 aryl group, a substituted or unsubstituted C5 to C30 heteroaryl group and a substituted or unsubstituted C6~ C30 arylamine group, or adjacent two R₂₁, R₂₂, R₂₃ and R₂₄ are connected (linked, joined, bonded or combined) to each other, together with the atoms to which they are attached, to form a 6 to 30 membered fused ring having ring boron and nitrogen atoms, optionally further substituted with one or substituents selected from the group consisting of a substituted or unsubstituted C6 to C30 aryl group and a substituted or unsubstituted C6 to C30 arylamine group. Each of R₂₅, R₂₆, R₂₇ and R₂₈ is independently selected from the group consisting of a substituted or unsubstituted C1 to C10 alkyl group, a substituted or unsubstituted C6 to C30 aryl group, a substituted or unsubstituted C5 to C30 heteroaryl group and a substituted or unsubstituted C6~ C30 arylamine group. Each of c1 and c3 is independently an integer of 0 to 5, c2 is an integer of 0 to 4, and c4 is an integer of 0 to 3.

For example, each of R₂₁, R₂₂, R₂₃ and R₂₄ may be independently selected from hydrogen and a substituted or unsubstituted C1 to C10 alkyl group, or adjacent two, e.g., R₂₂ and R₂₃ may be connected to each other to form an optionally substituted fused ring having ring boron and nitrogen atoms.

The fourth compound 322 may be one of the compounds in Formula 8.

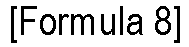

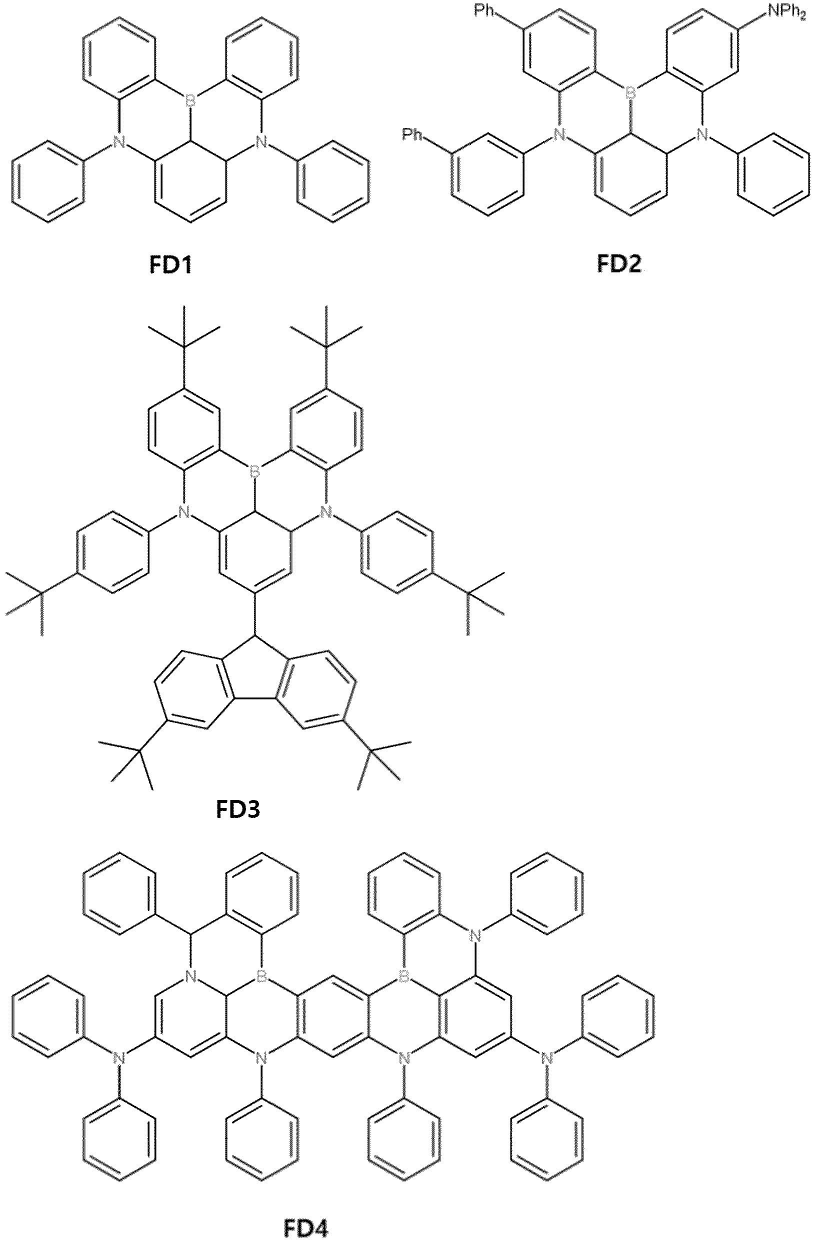

The fifth compound 324 is represented by Formula 9.

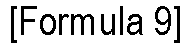

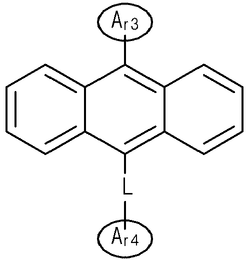

In Formula 9, each of Ar₃ and Ar₄ is independently selected from the group consisting of a substituted or unsubstituted C6 to C30 aryl group and a substituted or unsubstituted C5 to C30 heteroaryl group, and L is a single bond or a C6 to C30 arylene group.

For example, each of Ar₃ and Ar₄ may be independently selected from phenyl, naphthyl and phenylnaphthyl, and L may be a single bond or phenylene.

The fifth compound 324 may be one of the compounds in Formula 10.

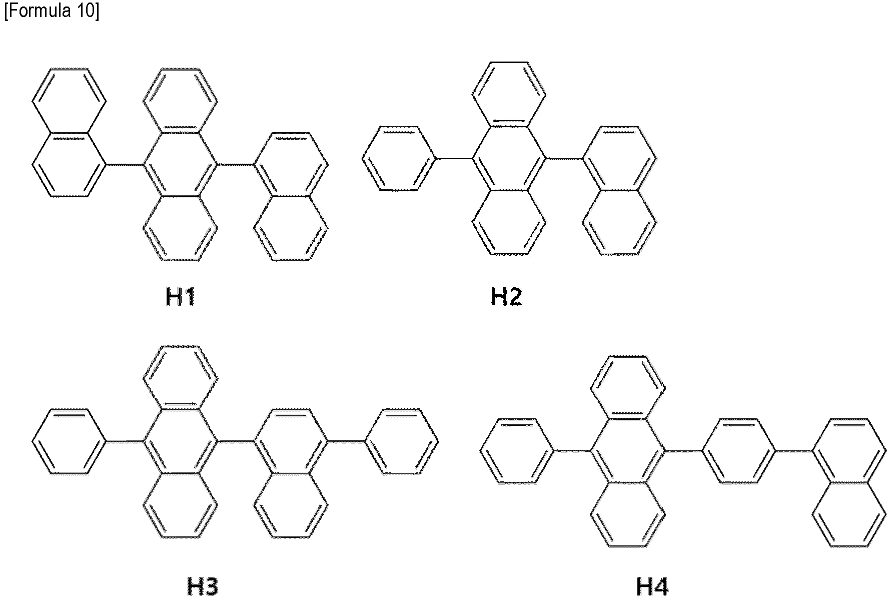

In the first blue EML 320, a weight % of the fifth compound 324 may be greater than a weight % of the fourth compound 322. For example, with respect to the fifth compound 324, the fourth compound 322 may have a weight % of 0.1 to 10.

The weight % of the fourth compound 322 being the emitter in the first blue EML 320 may be smaller than that of the first compound 362 being the emitter in the second EML 360.

The first blue EML 320 has a first thickness t1, and the second blue EML 360 has a second thickness t2 being greater than the first thickness t1.

Since the recombination zone of the hole and the electron in the first blue EML 320 is presented at an interface between the first blue EML 320 and the first HBL 317, the first blue EML 320 has a relatively small thickness to provide strong cavity effect. On the other hand, since the recombination zone of the hole and the electron in the second blue EML 360 is presented in a center of the second blue EML 360, the second blue EML 360 has a relatively large thickness to increase the lifespan of the OLED D1.

A ration "t1/t2" of the first thickness t1 to the second thickness t2 may be about 0.6 or less. For example, the first thickness t1 may be 10nm or more and 30nm or less, and the second thickness t2 may be 15nm or more and 50nm or less.

A difference between an average emission wavelength or a maximum emission wavelength of the fluorescent dopant of the first blue EML 320 and an average emission wavelength or a maximum emission wavelength of the phosphorescent dopant of the second blue EML 360 may be 20nm or less. For example, each of the average emission of the first blue EML 320 and the average wavelength of the second blue EML 360 may be a range of 450 to 490nm.

Emission wavelength may be measured at room temperature (i.e. 25°C) in an organic solvent, such as toluene. For example, solution of the fluorescent or phosphorescent dopant in an organic solvent (such as toluene) having a concentration of about 1 x 10⁻⁵ M may be used. The emission wavelength may be measured using a fluorescence spectrometer, such as FS-5 Fluorescence spectrometer (Edinburgh Instruments), with photoluminescence detection.

Each of the first and second HTLs 313 and 351 may include a compound in Formula 11.

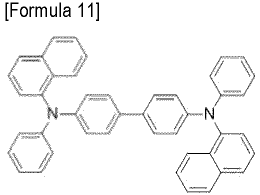

Alternatively, each of the first and second HTLs 313 and 351 may include one compound selected from the group consisting of N,N'-diphenyl-N,N'-bis(3-methylphenyl)-1,1'-biphenyl-4,4'-diamine (TPD), NPB(NPD), 4,4'-bis(N-carbazolyl)-1,1'-biphenyl (CBP), poly[N,N'-bis(4-butylpnehyl)-N,N'-bis(phenyl)-benzidine] (poly-TPD), (poly[(9,9-dioctylfluorenyl-2,7-diyl)-co-(4,4'-(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, and N-(biphenyl-4-yl)-N-(4-(9-phenyl-9H-carbazol-3-yl)phenyl)biphenyl-4-amine.

Each of the first and second HTLs 313 and 351 may have a thickness of 10 to 60nm. The thickness of the first HTL 313 and the thickness of the second HTL 351 may be same or different. For example, the thickness of the second HTL 351 may be greater than the thickness of the first HTL 313.

The HIL 311 may include the compound in Formula 11 and a compound in Formula 12. In this instance, the compound in Formula 12 may be doped with about 1 to 10 wt%.

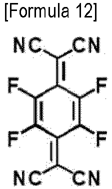

Alternatively, the HIL 311 may include one compound selected from the group consisting of 4,4',4"-tris(3-methylphenylamino)triphenylamine (MTDATA), 4,4',4"-tris(N,N-diphenyl-amino)triphenylamine (NATA), 4,4',4"-tris(N-(naphthalene-1-yl)-N-phenyl-amino)triphenylamine (1T-NATA), 4,4',4"-tris(N-(naphthalene-2-yl)-N-phenyl-amino)triphenylamine (2T-NATA), copper phthalocyanine(CuPc), tris(4-carbazoyl-9-yl-phenyl)amine (TCTA), N,N'-diphenyl-N,N'-bis(1-naphthyl)-1,1'-biphenyl-4,4"-diamine (NPB or NPD), 1,4,5,8,9,11-hexaazatriphenylenehexacarbonitrile (dipyrazino[2,3-f:2'3'-h]quinoxaline-2,3,6,7,10,11-hexacarbonitrile (HAT-CN)), 1,3,5-tris[4-(diphenylamino)phenyl]benzene (TDAPB), poly(3,4-ethylenedioxythiphene)polystyrene sulfonate (PEDOT/PSS), and N-(biphenyl-4-yl)-9,9-dimethyl-N-(4-(9-phenyl-9H-carbazol-3-yl)phenyl)-9H-fluoren-2-amine. The HIL 311 may have a thickness of 5 to 20nm.

Each of the first and second ETLs 319 and 357 may include a compound in Formula 13.

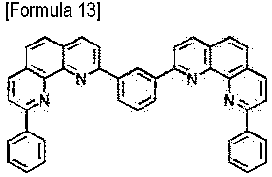

Alternatively, each of the first and second ETLs 319 and 357 may include one compound selected from the group consisting of tris-(8-hydroxyquinoline aluminum (Alq₃), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,O8)-(1,1'-biphenyl-4-olato)aluminum (BAlq), 4,7-diphenyl-1,10-phenanthroline (Bphen), 2,9-bis(naphthalene-2-yl)-4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), 1,3,5-tri(p-pyrid-3-yl-phenyl)benzene (TpPyPB), 2,4,6-tris(3'-(pyridin-3-yl)biphenyl-3-yl)1,3,5-triazine (TmPPPyTz), Poly[9,9-bis(3'-((N,N-dimethyl)-N-ethylammonium)-propyl)-2,7-fluorene]-alt-2,7-(9,9-dioctylfluorene)] (PFNBr), tris(phenylquinoxaline) (TPQ), and diphenyl-4-triphenylsilyl-phenylphosphine oxide (TSPO1).

Each of the first and second ETLs 319 and 357 may have a thickness of 5 to 60nm. For example, the thickness of the first ETL 319 may be smaller than that of the second ETL 357.

The EIL 359 may include at least one of an alkali halide compound, such as LiF, CsF, NaF, or BaF₂, and an organometallic compound, such as Liq, lithium benzoate, or sodium stearate. The EIL 359 may have a thickness of 1 to 10nm.

Each of the first and second EBLs 315 and 353 may include the compound in Formula 5 or a compound in Formula 14, e.g., TAPC.

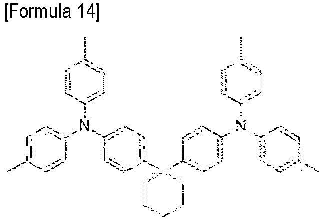

For example, the first EBL 315, which is adjacent to or contacts the first blue EML 320, may include the compound in Formula 14, and the second EBL 353, which is adjacent to or contacts the second blue EML 360, may include the compound in Formula 5, which is the third compound 366 in the second blue EML 360.

Alternatively, each of the first and second EBLs 315 and 353 may include one compound selected from the group consisting of TCTA, tris[4-(diethylamino)phenyl]amine, N-(biphenyl-4-yl)-9,9-dimethyl-N-(4-(9-phenyl-9H-carbazol-3-yl)phenyl)-9H-fluoren-2-amine, TAPC, MTDATA, 1,3-bis(carbazol-9-yl)benzene (mCP), 3,3'-bis(N-carbazolyl)-1,1'-biphenyl (mCBP), CuPc, N,N'-bis[4-[bis(3-methylphenyl)amino]phenyl]-N,N'-diphenyl-[1,1'-biphenyl]-4,4'-diamine (DNTPD), TDAPB, DCDPA, and 2,8-bis(9-phenyl-9H-carbazol-3-yl)dibenzo[b,d]thiophene).

Each of the first and second EBLs 315 and 353 may have a thickness of 10 to 30nm. The thickness of the first EBL 315 may be smaller than that of the second EBL 353.

Each of the first and second HBLs 317 and 355 may include the compound in Formula 3 or a compound in Formula 15, e.g., B3PYMPM.

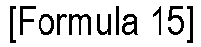

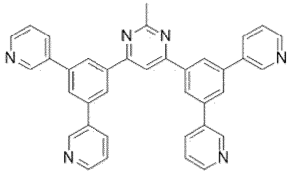

For example, the first HBL 317, which is adjacent to or contacts the first blue EML 320, may include the compound in Formula 15, and the second HBL 353, which is adjacent to or contacts the second blue EML 360, may include the compound in Formula 3, which is the second compound 364 in the second blue EML 360.

Alternatively, each of the first and second HBLs 317 and 355 may include BCP, BAlq, Alq3, PBD, spiro-PBD, Liq, bis-4,6-(3,5-di-3-pyridylphenyl)-2-methylpyrimidine (B3PYMPM), bis[2-(diphenylphosphino)phenyl]ether oxide (DPEPO), 9-(6-9H-carbazol-9-yl)pyridine-3-yl)-9H-3,9'-bicarbazole, and TSPO1. Each of the first and second HBLs 317 and 355 may have a thickness of 1 to 10nm. The first and second HBLs 317 and 355 may have the same thickness.

The N-type CGL 392 may include a host, which may be the material of the ETLs 319 and 357, and an n-type dopant. The n-type dopant may be lithium (Li) and may be doped with 0.1 to 10wt%.

The P-type CGL 394 may include a host, which may be the material of the HTLs 313 and 351, and an p-type dopant. The p-type dopant may be the compound in Formula 12 and may be doped with 5 to 20wt%.

Each of the N-type CGL 392 and the P-type CGL 394 may have a thickness of 1 to 20nm. In addition, the thickness of the N-type CGL 392 may be greater than the thickness of the P-type CGL 394.

The capping layer 290 is positioned on the second electrode 230 being the transparent electrode. For example, the capping layer 290 may include the material of the HTLs 313 and 351 and may have a thickness of 10 to 100nm.

The OLED D1 includes the first emitting part 310 including a fluorescent emitting layer and the second emitting part 350 including a phosphorescent emitting layer, and the second emitting part 350 is disposed to be closer to the transparent electrode. In addition, in the phosphorescent emitting layer, a ratio "I_{2nd}/I^{1st}" of a second emission peak intensity to a first emission peak intensity is 0.5 or less. As a result, the OLED D1 has advantages in the emitting efficiency and the lifespan.

Moreover, the phosphorescent emitting layer has a thickness greater than the fluorescent emitting layer so that the lifespan of the OLED D1 is significantly increased.

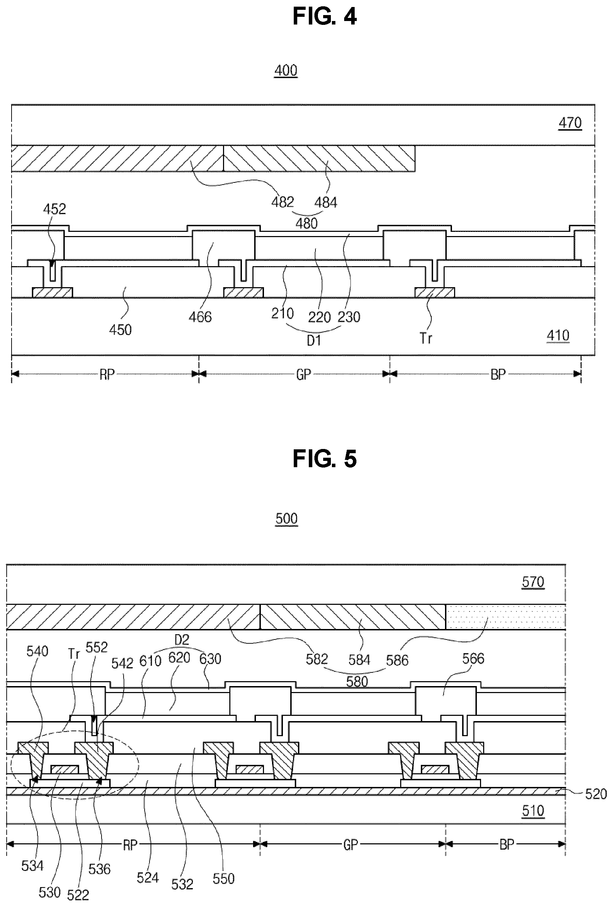

FIG. 4 is a schematic cross-sectional view of an organic light emitting display device according to a third embodiment of the present disclosure.

As shown in FIG. 4, the organic light emitting display device 400 includes a first substrate 410, where a red pixel RP, a green pixel GP and a blue pixel BP are defined, a second substrate 470 facing the first substrate 410, an OLED D1, which is positioned between the first and second substrates 410 and 470 and providing white emission, and a color conversion layer 480 between the OLED D1 and the second substrate 470.

Each of the first and second substrates 410 and 470 may be a glass substrate or a flexible substrate. For example, each of the first and second substrates 410 and 470 may be a polyimide (PI) substrate, a polyethersulfone (PES) substrate, a polyethylenenaphthalate (PEN) substrate, a polyethylene terephthalate (PET) substrate or a polycarbonate (PC) substrate.

A TFT Tr, which corresponding to each of the red, green and blue pixels RP, GP and BP, is formed on the first substrate 410, and a passivation layer 450, which has a drain contact hole 452 exposing an electrode, e.g., a drain electrode, of the TFT Tr is formed to cover the TFT Tr.

The OLED D1 including a first electrode 210, an organic light emitting layer 220 and a second electrode 230 is formed on the passivation layer 450. In this instance, the first electrode 210 may be connected to the drain electrode of the TFT Tr through the drain contact hole 452.

A bank layer 466 is formed on the passivation layer 450 and at a boundary of each of the red pixel region RP, the green pixel region GP and the blue pixel region BP to cover an edge of the first electrode 210.

The OLED D1 is disposed in each of the red pixel region RP, the green pixel region GP and the blue pixel region BP and emits a blue light.

The first electrode 210 may be anode, and the second electrode 230 may be a cathode. The first electrode 210 is a reflective electrode, and the second electrode 230 is a transparent electrode (or a semi-transparent electrode). For example, the first electrode 210 may have a structure of ITO/Ag/ITO, and the second electrode 230 may be formed of MgAg.

The organic light emitting layer 220 may have a structure shown in FIG. 3. Namely, the organic light emitting layer 220 includes the first emitting part 310 including the first blue EML 320, i.e., a fluorescent emitting layer, and the second emitting part 350 including the second blue EML 360, i.e., a phosphorescent emitting layer, and the second blue EML 360 being the phosphorescent emitting layer is disposed to be closer to the second electrode 230 being the transparent electrode.

The second blue EML 360 includes the first compound 362 represented by Formula 1, the second compound 364 represented by Formula 3 and the third compound 366 represented by Formula 5, and the first blue EML 320 includes the fourth compound 322 represented by Formula 7 and the fifth compound 324 represented by Formula 9.

In the second blue EML 360, a ratio "I_{2nd}/I₁ₛₜ" of the second emission peak intensity "I_{2nd}" to the first emission peak intensity "I₁ₛₜ" is 0.5 or less. Namely, in the first compound 362, the ratio of the second emission peak intensity to the first emission peak intensity is relatively smaller. For example, in the first compound 362, a ratio "I_{2nd}/I₁ₛₜ" of the second emission peak intensity "I_{2nd}" to the first emission peak intensity "I₁ₛₜ" is 0.5 or less.

In addition, the first blue EML 320 has a first thickness t1, and the second blue EML 360 has a second thickness t2 being greater than the first thickness t1. A ratio "t1/t2" of the first thickness t1 to the second thickness may be about 0.6 or less.

The color conversion layer 480 includes a first color conversion layer 482 corresponding to the red pixel RP and a second color conversion layer 484 corresponding to the green pixel GP. For example, the color conversion layer 480 may include an inorganic color conversion material such as a quantum dot.

The blue light from the OLED D1 is converted into the red light by the first color conversion layer 482 in the red pixel region RP, and the blue light from the OLED D1 is converted into the green light by the second color conversion layer 484 in the green pixel region GP.

Although not shown, a color filter may be formed between the second substrate 470 and the color conversion layer 480. For example, a red color filter may be formed between the first color conversion layer 482 and the second substrate 470, and a green color filter may be formed between the second color conversion layer 484 and the second substrate 470.

Accordingly, the organic light emitting display device 400 can display a full-color image.

On the other hand, when the light from the OLED D passes through the first substrate 410, the color conversion layer 480 is disposed between the OLED D and the first substrate 410. In this case, the second emitting part 350 including the second blue EML 360, i.e., the phosphorescent emitting layer, is disposed to be closer to the first electrode 210, and the first emitting part 310 including the first blue EML 320, i.e., the fluorescent emitting layer, is disposed between the second emitting part 350 and the second electrode 230.

In the organic light emitting display device 400 of the present disclosure, the OLED D1 providing the blue emission is disposed in all of the red, green and blue pixel regions RP, GP and BP, and the color conversion layer 480 is used to provide full color image.

In addition, in the OLED D1 including a fluorescent emitting layer and a phosphorescent emitting layer, a ratio "I_{2nd}/I₁ₛₜ" of the second emission peak intensity of the phosphorescent emitting layer to the first emission peak intensity of the phosphorescent emitting layer is 0.5 or less so that the organic light emitting display device 400 has the advantages in the emitting efficiency and the lifespan.

Moreover, the phosphorescent emitting layer has a thickness being greater than the fluorescent emitting layer so that the lifespan of the organic light emitting display device 400 is significantly increased.

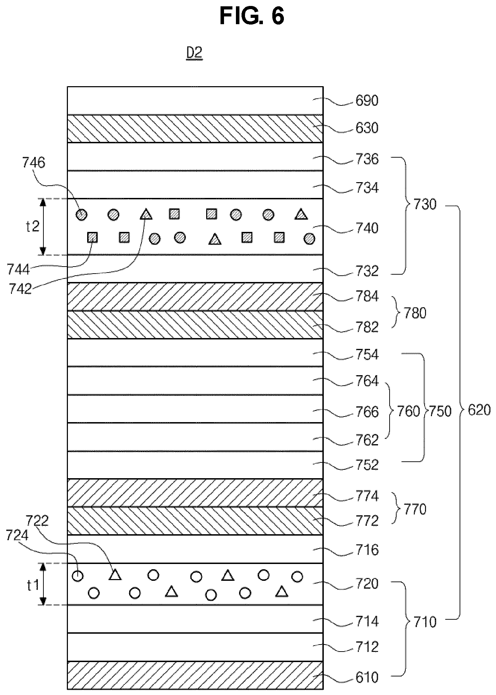

FIG. 5 is a schematic cross-sectional view of an organic light emitting display device according to a fourth embodiment of the present disclosure, and FIG. 6 is a schematic cross-sectional view of an OLED according to a fifth embodiment of the present disclosure.

As shown in FIG. 5, the organic light emitting display device 500 includes a first substrate 510, where a red pixel region RP, a green pixel region GP and a blue pixel region BP are defined, a second substrate 570 facing the first substrate 510, an OLED D, which is positioned between the first and second substrates 510 and 570 and providing white emission, and a color filter layer 580 between the OLED D and the second substrate 570.

Each of the first and second substrates 510 and 570 may be a glass substrate or a flexible substrate. For example, each of the first and second substrates 510 and 570 may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 520 is formed on the substrate, and the TFT Tr corresponding to each of the red, green and blue pixel regions RP, GP and BP is formed on the buffer layer 520. The buffer layer 520 may be omitted.

A semiconductor layer 522 is formed on the buffer layer 520. The semiconductor layer 522 may include an oxide semiconductor material or polycrystalline silicon.

A gate insulating layer 524 is formed on the semiconductor layer 522. The gate insulating layer 524 may be formed of an inorganic insulating material such as silicon oxide or silicon nitride.

A gate electrode 530, which is formed of a conductive material, e.g., metal, is formed on the gate insulating layer 524 to correspond to a center of the semiconductor layer 522.

An interlayer insulating layer 532, which is formed of an insulating material, is formed on the gate electrode 530. The interlayer insulating layer 532 may be formed of an inorganic insulating material, e.g., silicon oxide or silicon nitride, or an organic insulating material, e.g., benzocyclobutene or photo-acryl.

The interlayer insulating layer 532 includes first and second contact holes 534 and 536 exposing both sides of the semiconductor layer 522. The first and second contact holes 534 and 536 are positioned at both sides of the gate electrode 530 to be spaced apart from the gate electrode 530.

A source electrode 540 and a drain electrode 542, which are formed of a conductive material, e.g., metal, are formed on the interlayer insulating layer 532.

The source electrode 540 and the drain electrode 542 are spaced apart from each other with respect to the gate electrode 530 and respectively contact both sides of the semiconductor layer 522 through the first and second contact holes 534 and 536.

The semiconductor layer 522, the gate electrode 530, the source electrode 540 and the drain electrode 542 constitute the TFT Tr. The TFT Tr serves as a driving element. Namely, the TFT Tr may correspond to the driving TFT Td (of FIG. 1).

Although not shown, the gate line and the data line cross each other to define the pixel region, and the switching TFT is formed to be connected to the gate and data lines. The switching TFT is connected to the TFT Tr as the driving element.

In addition, the power line, which may be formed to be parallel to and spaced apart from one of the gate and data lines, and the storage capacitor for maintaining the voltage of the gate electrode of the TFT Tr in one frame may be further formed.

A passivation layer (planarization layer) 550, which includes a drain contact hole 552 exposing the drain electrode 542 of the TFT Tr, is formed to cover the TFT Tr.

A first electrode 610, which is connected to the drain electrode 542 of the TFT Tr through the drain contact hole 552, is separately formed in each pixel region and on the passivation layer 550. The first electrode 610 may be an anode and may include a transparent conductive oxide material layer, which is formed of a conductive material, e.g., a transparent conductive oxide (TCO) material, having a relatively high work function, and a reflection layer. Namely, the first electrode 610 is a reflection electrode.

Alternatively, the first electrode 610 may have a single-layered structure of the transparent conductive oxide material layer. Namely, the first electrode 610 may be a transparent electrode.

For example, the transparent conductive oxide material layer may be formed of one of indium-tin-oxide (ITO), indium-zinc-oxide (IZO), indium-tin-zinc-oxide (ITZO), tin oxide (SnO), zinc oxide (ZnO), indium-copper-oxide (ICO) and aluminum-zinc-oxide (Al:ZnO, AZO), and the reflection layer may be formed of one of silver (Ag), an alloy of Ag and one of palladium (Pd), copper (Cu), indium (In) and neodymium (Nd), and aluminum-palladium-copper (APC) alloy. For example, the first electrode 610 may have a structure of ITO/Ag/ITO or ITO/APC/ITO.

A bank layer 566 is formed on the passivation layer 550 to cover an edge of the first electrode 610. Namely, the bank layer 566 is positioned at a boundary of the red, green and blue pixel regions RP, GP and BP and exposes a center of the first electrode 610 in the red, green and blue pixel regions RP, GP and BP. The bank layer 566 may be omitted.

An organic light emitting layer 620 is formed on the first electrode 610, and a second electrode 630 is formed over the first substrate 510 including the organic light emitting layer 620.

In the organic light emitting display device 500, since the light emitted from the organic emitting layer 620 is incident to the color filter layer 580 through the second electrode 630, the second electrode 630 has a thin profile for transmitting the light.

Namely, the second electrode is disposed on an entire of a display area and is formed of a conductive material having a relatively low work function to serve as a cathode. For example, the second electrode 630 may be formed of Al, Mg, Ca, Ag or their alloy, e.g., MgAg. The second electrode 630 has a thin profile, e.g., a thickness of 10 to 30nm, to have a light transparent (semitransparent) property.

The first electrode 610, the organic light emitting layer 620 and the second electrode 630 constitute the OLED D2. In addition, the OLED D2 may further include a capping layer 690 for enhancing the light extraction.

Referring to FIG. 6, the organic light emitting layer 620 includes a first emitting part 710 including a first blue EML 720, i.e., a fluorescent emitting layer, a second emitting part 730 including a second blue EML 740, i.e., a phosphorescent emitting layer, and a third emitting part 750 including a third EML 760, which emits red and green light. In addition, the organic light emitting layer 620 may further include a first CGL 770 between the first and third emitting parts 710 and 750 and a second CGL 780 between the second and third emitting parts 730 and 750.

The organic light emitting display device 500 includes red, green and blue pixel regions RP, GP and BP, and the OLED D2 emits a white light in the red, green and blue pixel regions RP, GP and BP.

The first emitting part 710 may further include at least one a first HTL 714 under the first blue EML 720 and a first ETL 716 on the first blue EML 720. In addition, the first emitting part 710 may further include an HIL 712 under the first HTL 714.

Although not shown, the first emitting part 710 may further include at least one of a first EBL between the first blue EML 720 and the first HTL 714 and a first HBL between the first EML 720 and the first ETL 716.

The second emitting part 730 may further include at least one of a second HTL 732 under the second blue EML 740 and a second ETL 734 on the second blue EML 740. In addition, the second emitting part 730 may further include an EIL 736 on the second ETL 734.

Although not shown, the second emitting part 730 may further include at least one of a second EBL between the second blue EML 740 and the second HTL 732 and a second HBL between the second blue EML 740 and the second ETL 734.

In the third emitting part 750, the third EML 760 includes a red EML 762 and a green EML 764. The green EML 764 is positioned between the red EML 762 and the third emitting part 730. In addition, the third EML 760 may further include a yellow-green EML 766 between the red and green EMLs 762 and 764.

The red EML includes a red host and a red dopant, the green EML includes a green host and a green dopant, and the yellow-green EML includes a yellow-green host and a yellow-green dopant. Each of the red dopant, the green dopant and the yellow-green dopant may be one of a fluorescent compound, a phosphorescent compound and a delayed fluorescent compound.

The third emitting part 750 may further include a third HTL 752 under the third EML 760 and a third ETL 754 on the third EML 760.

Although not shown, the third emitting part 750 may further include at least one of a third EBL between the third blue EML 760 and the third HTL 752 and a third HBL between the third blue EML 760 and the third ETL 754.

The first CGL 770 is positioned between the first emitting part 710 and the third emitting part 750, and the second CGL 780 is positioned between the second emitting part 730 and the third emitting part 750. Namely, the first emitting part 710, the first CGL 770, the third emitting part 750, the second CGL 780 and the third emitting part 730 are sequentially stacked on the first electrode 610. In other words, the first emitting part 710 is positioned between the first electrode 610 and the first CGL 770, the third emitting part 750 is positioned between the first and second CGLs 770 and 780, and the second emitting part 730 is positioned between the second CGL 780 and the second electrode 630.

The first CGL 770 may be a P-N junction CGL of a first N-type CGL 772 and a first P-type CGL 774, and the second CGL 780 may be a P-N junction CGL of a second N-type CGL 782 and a second P-type CGL 784.

In the first CGL 770, the first N-type CGL 772 is positioned between the first ETL 716 and the third HTL 752, and the first P-type CGL 774 is positioned between the first N-type CGL 772 and the third HTL 752.

In the second CGL 780, the second N-type CGL 782 is positioned between the third ETL 754 and the second HTL 732, and the second P-type CGL 784 is positioned between the second N-type CGL 782 and the second HTL 732.

The second blue EML 740 includes the first compound 742 represented by Formula 1, the second compound 744 represented by Formula 3 and the third compound 746 represented by Formula 5, and the first blue EML 720 includes the fourth compound 722 represented by Formula 7 and the fifth compound 724 represented by Formula 9.

In the second blue EML 740, a ratio "I_{2nd}/I₁ₛₜ" of the second emission peak intensity "I_{2nd}" to the first emission peak intensity "I₁ₛₜ" is 0.5 or less. Namely, in the first compound 742, the ratio of the second emission peak intensity to the first emission peak intensity is relatively smaller. For example, in the first compound 742, a ratio "I_{2nd}/I₁ₛₜ" of the second emission peak intensity "I_{2nd}" to the first emission peak intensity "I₁ₛₜ" is 0.5 or less.

In addition, the first blue EML 720 has a first thickness t1, and the second blue EML 740 has a second thickness t2 being greater than the first thickness t1. A ratio "t1/t2" of the first thickness t1 to the second thickness may be about 0.6 or less.

Referring back to FIG. 5, the color filter layer 580 is positioned over the OLED D2 and includes a red color filter 582, a green color filter 584 and a blue color filter 586 respectively corresponding to the red pixel region RP, the green pixel region GP and the blue pixel region BP.

The red color filter 582 may include at least one of red dye and red pigment, the green color filter 584 may include at least one of green dye and green pigment, and the blue color filter 586 may include at least one of blue dye and blue pigment.

Although not shown, the color filter layer 580 may be attached to the OLED D2 by using an adhesive layer. Alternatively, the color filter layer 580 may be formed directly on the OLED D2.

An encapsulation film (not shown) may be formed to prevent penetration of moisture into the OLED D2. For example, the encapsulation film may include a first inorganic insulating layer, an organic insulating layer and a second inorganic insulating layer sequentially stacked, but it is not limited thereto. The encapsulation film may be omitted.

A polarization plate (not shown) for reducing an ambient light reflection may be disposed on an outer side of the second electrode 570. For example, the polarization plate may be a circular polarization plate.

In the OLED of FIG. 5, the light from the organic light emitting layer 620 passes through the second electrode 630, and the color filter layer 580 is disposed over the OLED D2. Alternatively, when the light from the organic light emitting layer 620 passes through the first electrode 610, the color filter layer 580 may be disposed between the OLED D2 and the first substrate 510. In this instance, the second emitting part 730 including the second blue EML 740, i.e., the phosphorescent emitting layer, is disposed closer to the first electrode 610, and the first emitting part 710 including the first blue EML 720, i.e., the fluorescent emitting layer, is disposed between the third emitting part 740 and the second electrode 630.

A color conversion layer (not shown) may be formed between the OLED D2 and the color filter layer 580. The color conversion layer may include a red color conversion layer, a green color conversion layer and a blue color conversion layer respectively corresponding to the red, green and blue pixel regions RP, GP and BP. The white light from the OLED D is converted into the red light, the green light and the blue light by the red, green and blue color conversion layer, respectively. For example, the color conversion layer may include a quantum dot. Accordingly, the color purity of the organic light emitting display device 400 may be further improved.

As described above, in the organic light emitting display device 500, the OLED D2 in the red, green and blue pixel regions RP, GP and BP emits the white light, and the white light from the organic light emitting diode D2 passes through the red color filter 582, the green color filter 584 and the blue color filter 586. As a result, the red light, the green light and the blue light are provided from the red pixel region RP, the green pixel region GP and the blue pixel region BP, respectively.

In FIG. 5, the OLED D2 emitting the white light is used for a display device. Alternatively, the OLED D2 may be formed on an entire surface of a substrate without at least one of the driving element and the color filter layer to be used for a lightening device. The display device and the lightening device each including the OLED D2 of the present disclosure may be referred to as an organic light emitting device.

In the organic light emitting display device 500 according to the present disclosure, the OLED D2, which emits the white light, is disposed in the red, green and blue pixel regions RP, GP and BP, and the color filter layer 580 is used to provide a full color image.

In addition, in the OLED D2 including a fluorescent emitting layer and a phosphorescent emitting layer, which is disposed to be closer to the transparent electrode, a ratio "I_{2nd}/I₁ₛₜ" of the second emission peak intensity of the phosphorescent emitting layer to the first emission peak intensity of the phosphorescent emitting layer is 0.5 or less so that the organic light emitting display device 500 has the advantages in the emitting efficiency and the lifespan.

Moreover, the phosphorescent emitting layer has a thickness being greater than the fluorescent emitting layer so that the lifespan of the organic light emitting display device 500 is significantly increased.

### [OLED]

An anode (ITO(7nm)/Ag(10nm)/ITO(7nm)), an HIL (the compound in Formula 11 and the compound in Formula 12 (5wt%), 10nm), a first HTL (the compound in Formula 11, 20nm), a first EBL (the compound in Formula 14, 15nm), a first EML, a first HBL (the compound in Formula 15, 5nm), a first ETL (the compound in Formula 13, 10nm), an N-type CGL (the compound in Formula 13 and Li (1wt%), 10nm), a P-type CGL (the compound in Formula 11 and the compound in Formula 12 (15wt%), 5nm), a second HTL (the compound in Formula 11), a second EBL (the compound NH3 in Formula 6, 20nm), a second EML, a second HBL (the compound PH1 in Formula 4, 5nm), a second ETL (the compound in Formula 13, 45nm), an EIL (LiF, 2nm), a cathode (AgMg (Mg=10wt%), 10nm) and a capping layer (the compound in Formula 11, 65nm) are sequentially deposited to form an OLED.

### 1. Comparative Examples

### (1) Comparative Example 1 (Ref1)

The compound FD1 in Formula 8 (2wt%) and the compound H1 in Formula 10 (98wt%) are used to form the first EML (20nm) and the second EML (20nm). The second HTL is formed with a thickness of 12.5nm.

### (2) Comparative Example 2 (Ref2)

The compound PD3 in Formula 2 (12wt%), the compound PH1 in Formula 4 (44wt%) and the compound NH3 in Formula 6 (44wt%) are used to form the first EML (20nm) and the second EML (20nm). The second HTL is formed with a thickness of 42.5nm.

### (3) Comparative Example 3 (Ref3)

The compound PD3 in Formula 2 (12wt%), the compound PH1 in Formula 4 (44wt%) and the compound NH3 in Formula 6 (44wt%) are used to form the first EML (20nm), and the compound FD1 in Formula 8 (2wt%) and the compound H1 in Formula 10 (98wt%) are used to form the second EML (20nm). The second HTL is formed with a thickness of 27.5nm.

### (4) Comparative Example 4 (Ref4)

The compound FD1 in Formula 8 (2wt%) and the compound H1 in Formula 10 (98wt%) are used to form the first EML (20nm), and the compound in Formula 16 (12wt%) and the compound PH1 in Formula 4 (44wt%) and the compound NH3 in Formula 6 (44wt%) are used to form the second EML (20nm). The second HTL is formed with a thickness of 30nm.

### (5) Comparative Example 5 (Ref5)

The compound FD1 in Formula 8 (2wt%) and the compound H1 in Formula 10 (98wt%) are used to form the first EML (20nm), and the compound in Formula 17 (12wt%), the compound PH1 in Formula 4 (44wt%) and the compound NH3 in Formula 6 (44wt%) are used to form the second EML (20nm). The second HTL is formed with a thickness of 30nm.

### 2. Examples

### (1) Example 1 (Ex1)

The compound FD1 in Formula 8 (2wt%) and the compound H1 in Formula 10 (98wt%) are used to form the first EML (20nm), and the compound PD3 in Formula 2 (12wt%), the compound PH1 in Formula 4 (44wt%) and the compound NH3 in Formula 6 (44wt%) are used to form the second EML (20nm). The second HTL is formed with a thickness of 27.5nm.

### (2) Example 2 (Ex2)

The compound FD1 in Formula 8 (2wt%) and the compound H1 in Formula 10 (98wt%) are used to form the first EML (20nm), and the compound PD3 in Formula 2 (12wt%), the compound PH1 in Formula 4 (44wt%) and the compound NH3 in Formula 6 (44wt%) are used to form the second EML (25nm). The second HTL is formed with a thickness of 27.5nm.

### (3) Example 3 (Ex3)

The compound FD1 in Formula 8 (2wt%) and the compound H1 in Formula 10 (98wt%) are used to form the first EML (17.5nm), and the compound PD3 in Formula 2 (12wt%), the compound PH1 in Formula 4 (44wt%) and the compound NH3 in Formula 6 (44wt%) are used to form the second EML (25nm). The second HTL is formed with a thickness of 27.5nm.

### (4) Example 4 (Ex4)

The compound FD1 in Formula 8 (2wt%) and the compound H1 in Formula 10 (98wt%) are used to form the first EML (15nm), and the compound PD3 in Formula 2 (12wt%), the compound PH1 in Formula 4 (44wt%) and the compound NH3 in Formula 6 (44wt%) are used to form the second EML (25nm). The second HTL is formed with a thickness of 27.5nm.

### (5) Example 5 (Ex5)

The compound FD1 in Formula 8 (2wt%) and the compound H1 in Formula 10 (98wt%) are used to form the first EML (15nm), and the compound PD3 in Formula 2 (12wt%), the compound PH1 in Formula 4 (44wt%) and the compound NH3 in Formula 6 (44wt%) are used to form the second EML (30nm). The second HTL is formed with a thickness of 27.5nm.

### (6) Example 6 (Ex6)

The compound FD1 in Formula 8 (2wt%) and the compound H1 in Formula 10 (98wt%) are used to form the first EML (20nm), and the compound PD4 in Formula 2 (12wt%), the compound PH1 in Formula 4 (44wt%) and the compound NH3 in Formula 6 (44wt%) are used to form the second EML (20nm). The second HTL is formed with a thickness of 27.5nm.

### (7) Example 7 (Ex7)

The compound FD1 in Formula 8 (2wt%) and the compound H1 in Formula 10 (98wt%) are used to form the first EML (15nm), and the compound PD4 in Formula 2 (12wt%), the compound PH1 in Formula 4 (44wt%) and the compound NH3 in Formula 6 (44wt%) are used to form the second EML (30nm). The second HTL is formed with a thickness of 27.5nm.

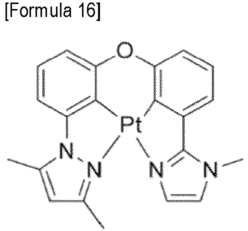

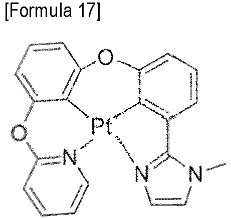

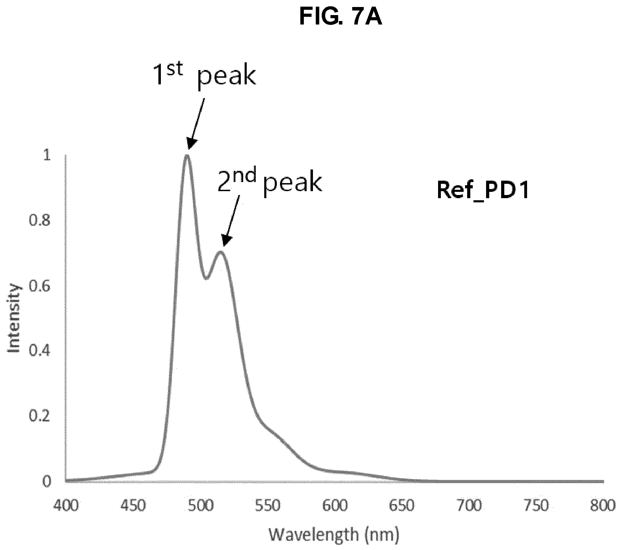

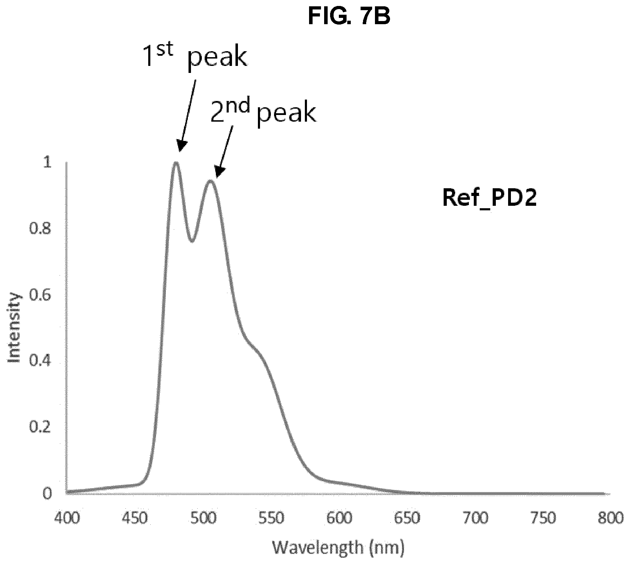

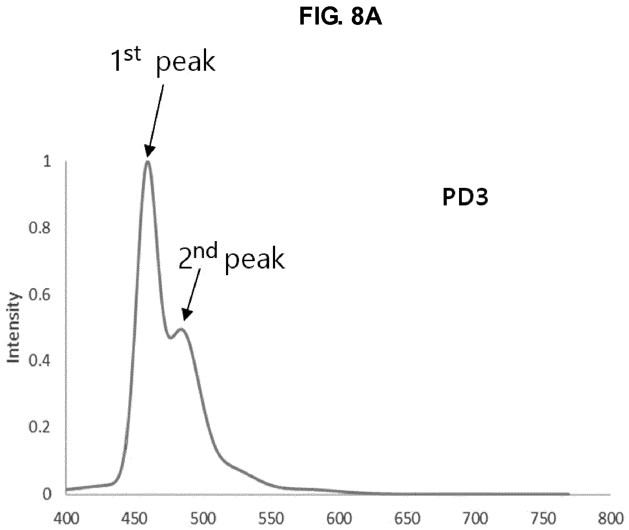

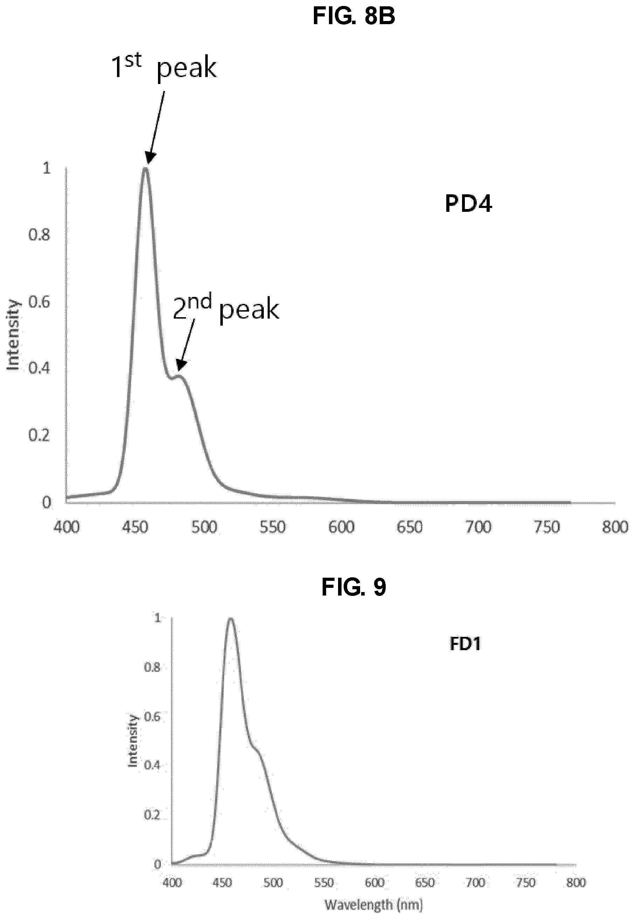

With the compound in Formula 16 "Ref_PD1", the compound in Formula 17 "Ref_PD2", the compound PD3 in Formula 2 and the compound PD4 in Formula 2, the maximum emission wavelength (λmax) and the ratio "I_{2nd}/I₁ₛₜ" of the second emission peak intensity to the first emission peak intensity are measured and listed in Table 1. In addition, the PL spectrum of the compound in Formula 16 "Ref_PD1" and the compound in Formula 17 "Ref_PD2" are respectively shown in FIGs. 7A and 7B, and the PL spectrum of the compound PD3 in Formula 2 and the compound PD4 in Formula 2 are respectively shown in FIGs. 8A and 8B. The PL spectrum of the compound FD1 in Formula 8 is shown in FIG. 9.

With the phosphorescent emitter "PD" used in the OLED of Comparative Examples 1 to 5 and Examples 1 to 7, the ratio "I_{2nd}/I₁ₛₜ" of the second emission peak intensity of phosphorescent emitter to the first emission peak intensity of phosphorescent emitter, the difference "△λmax= λmax(EML2)- λmax(EML1)" between the maximum emission peak wavelength (a first emission peak wavelength) of the first EML EML1 and the maximum emission peak wavelength of the second EML EML2, a thickness t1 of the first EML, a second thickness t2 of the second EML, a ratio "t1/t2" of the first thickness to the second thickness, and a thickness of the second HTL "t_{HTL2}" are listed in Table 2.

The emitting properties, i.e., the driving voltage (V), the luminance (cd/A), the color coordinate index (CIEx and CIEy), the blue index (BI, cd/A/CIEy) and the lifespan (T95), of the OLED in Comparative Examples 1 to 5 and Examples 1 to 7 are measured and listed in Table 3.

**Table 1**

| | λmax (nm) | I_{2nd}/I₁ₛₜ |
|---|---|---|
| Ref_PD1 | 490 | 0.70 |
| Ref_PD2 | 481 | 0.95 |
| PD3 | 460 | 0.50 |
| PD4 | 458 | 0.40 |

**Table 2**

| | PD | I_{2nd}/I₁ₛₜ | Δλmax | t1 (nm) | t2 (nm) | t1/t2 | tHTL2 (nm) |
|---|---|---|---|---|---|---|---|
| Ref1 | - | - | - | 20 | 20 | 1 | 12.5 |
| Ref2 | PD3 | 0.5 | - | 20 | 20 | 1 | 42.5 |
| Ref3 | PD3 | 0.5 | 1 | 20 | 20 | 1 | 27.5 |
| Ref4 | PD1 | 0.7 | 31 | 20 | 20 | 1 | 30 |
| Ref5 | PD2 | 0.95 | 22 | 20 | 20 | 1 | 30 |
| Ex1 | PD3 | 0.5 | 1 | 20 | 20 | 1 | 27.5 |
| Ex2 | PD3 | 0.5 | 1 | 20 | 25 | 0.8 | 27.5 |
| Ex3 | PD3 | 0.5 | 1 | 17.5 | 25 | 0.7 | 27.5 |
| Ex4 | PD3 | 0.5 | 1 | 15 | 25 | 0.6 | 27.5 |
| Ex5 | PD3 | 0.5 | 1 | 15 | 30 | 0.5 | 27.5 |
| Ex6 | PD4 | 0.4 | -1 | 20 | 20 | 1 | 27.5 |
| Ex7 | PD4 | 0.4 | -1 | 15 | 30 | 0.5 | 27.5 |

**Table 3**

| | V | cd/A | CIEx | CIEy | BI | T80 (hr) |
|---|---|---|---|---|---|---|
| Ref1 | 6.00 | 14.2 | 0.136 | 0.054 | 264 | >1000 |
| Ref2 | 6.10 | 29.6 | 0.137 | 0.055 | 544 | 100 |
| Ref3 | 5.80 | 20.0 | 0.137 | 0.055 | 364 | 190 |
| Ref4 | 6.00 | 21.1 | 0.118 | 0.125 | 169 | 190 |
| Ref5 | 6.20 | 21.8 | 0.120 | 0.111 | 197 | 220 |
| Ex1 | 6.20 | 21.7 | 0.135 | 0.054 | 398 | 200 |
| Ex2 | 6.30 | 22.9 | 0.136 | 0.053 | 429 | 210 |
| Ex3 | 6.20 | 22.8 | 0.136 | 0.053 | 430 | 210 |
| Ex4 | 5.90 | 22.8 | 0.136 | 0.053 | 431 | 230 |
| Ex5 | 6.10 | 21.6 | 0.136 | 0.052 | 415 | 270 |
| Ex6 | 5.80 | 21.2 | 0.138 | 0.049 | 432 | 150 |
| Ex7 | 5.80 | 21.1 | 0.139 | 0.047 | 452 | 300 |

As shown in Table 3, the OLED of Ref1, in which the first and second EMLs are a fluorescent emitting layer, has low emitting efficiency and low blue index. On the other hand, the OLED of Ref2, in which the first and second EMLs are a phosphorescent emitting layer, has low lifespan.

The OLED of Ref3, in which the first EML is a phosphorescent emitting layer and the second EML is a fluorescent emitting layer, has relatively low emitting efficiency, low blue index and low lifespan.

In the OLED of Ref4 and Ref5, the second EML being a phosphorescent emitting layer is disposed to be closer to the cathode being the transparent electrode than the first EML being a fluorescent emitting layer, while the ratio "I_{2nd}/I₁ₛₜ" of the second emission peak intensity of phosphorescent emitter to the first emission peak intensity of phosphorescent emitter and the difference "△λmax= λmax(EML2)- λmax(EML1)" between the maximum emission peak wavelength of the first EML EML1 and the maximum emission peak wavelength of the second EML EML2 do not meet the desired condition of the present disclosure. As a result, the OLED of Ref4 and Ref5 has low blue index.

In the OLED of Ex1 to Ex7, the second EML being a phosphorescent emitting layer is disposed to be closer to the cathode being the transparent electrode than the first EML being a fluorescent emitting layer, while the ratio "I_{2nd}/I₁ₛₜ" of the second emission peak intensity of phosphorescent emitter to the first emission peak intensity of phosphorescent emitter and the difference "△λmax= λmax(EML2)- λmax(EML1)" between the maximum emission peak wavelength of the first EML EML1 and the maximum emission peak wavelength of the second EML EML2 meet the desired condition of the present disclosure. Accordingly, the OLED of Ex1 to Ex7 has advantages in the driving voltage, the luminance, the color coordinate index, the blue index and the lifespan.

In addition, in the OLED of Ref2 to Ref5 and Ref6, the second EML being the phosphorescent emitting layer has a thickness greater than the first EML being the fluorescent emitting layer so that the property of the OLED is further improved.

Moreover, in the OLED of Ref4, Ref5 and Ref7, the ratio "t1/t2" of the thickness t1 of the first EML to the thickness t2 of the second EML is 0.6 or less so that the property of the OLED is further improved.

It will be apparent to those skilled in the art that various modifications and variations can be made in the present disclosure without departing from the scope of the present disclosure. Thus, it is intended that the present disclosure cover the modifications and variations of this disclosure provided they come within the scope of the appended claims.

## Claims

1. An organic light emitting diode, comprising:
a reflective electrode (210);
a transparent electrode (230) facing the reflective electrode (210);
a first emitting part (310) including a first blue emitting material layer (320) and positioned between the reflective electrode (210) and the transparent electrode (230), the first blue emitting material layer (320) being a fluorescent emitting layer comprising a fourth compound as a fluorescent dopant; and
a second emitting part (350) including a second blue emitting material layer (360) and positioned between the first emitting part (310) and the transparent electrode (230), the second blue emitting material layer (360) being a phosphorescent emitting layer comprising a first compound as a phosphorescent dopant,
**characterised in that**
a ratio of an intensity of a second emission peak of the first phosphorescent dopant compound in the second blue emitting material layer (360) to an intensity of a first emission peak of the first phosphorescent dopant compound in the second blue emitting material layer (360) is 0.5 or less,
wherein the first emission peak means a peak having the largest emission intensity, and the second emission peak means a peak having the second largest emission intensity.

2. The organic light emitting diode according to claim 1, wherein the first blue emitting material layer has a first thickness, and the second blue emitting material layer has a second thickness greater than the first thickness.

3. The organic light emitting diode according to claim 2, wherein a ratio of the first thickness to the second thickness is 0.6 or less.

4. The organic light emitting diode according to claim 3, wherein the first thickness is 10nm or more, and the second thickness is 50nm or less.

5. The organic light emitting diode according to claim 1, wherein a difference between a maximum emission wavelength of the fourth fluorescent dopant compound of the first blue emitting material layer and a maximum emission wavelength of the first phosphorescent dopant compound of the second blue emitting material layer is 20nm or less

6. The organic light emitting diode according to any preceding claim, wherein the second blue emitting material layer further includes a second compound as a first host and a third compound as a second host.

7. The organic light emitting diode according to claim 6, wherein the first compound is a platinum complex represented by Formula 1: 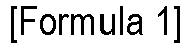 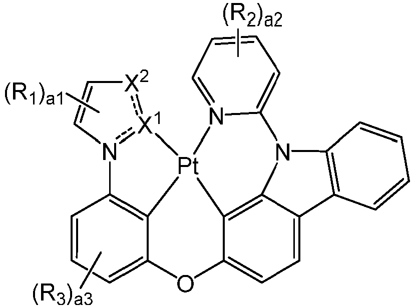
wherein each of R₁, R₂, and R₃ is independently selected from the group consisting of a substituted or unsubstituted C1 to C10 alkyl group, a substituted or unsubstituted C6 to C30 aryl group and a substituted or unsubstituted C5 to C30 heteroaryl group,
wherein a1 is an integer of 0 to 2, a2 is an integer of 0 to 4, and a3 is an integer of 0 to 4,
wherein X₁ is C or N, and X₂ is CR₄ or NR₄, and
wherein R₄ is selected from the group consisting of hydrogen, a substituted or unsubstituted C1 to C10 alkyl group, a substituted or unsubstituted C6 to C30 aryl group and a substituted or unsubstituted C5 to C30 heteroaryl group.

8. The organic light emitting diode according to claim 7, wherein the first compound is one of compounds of Formula 2

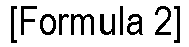

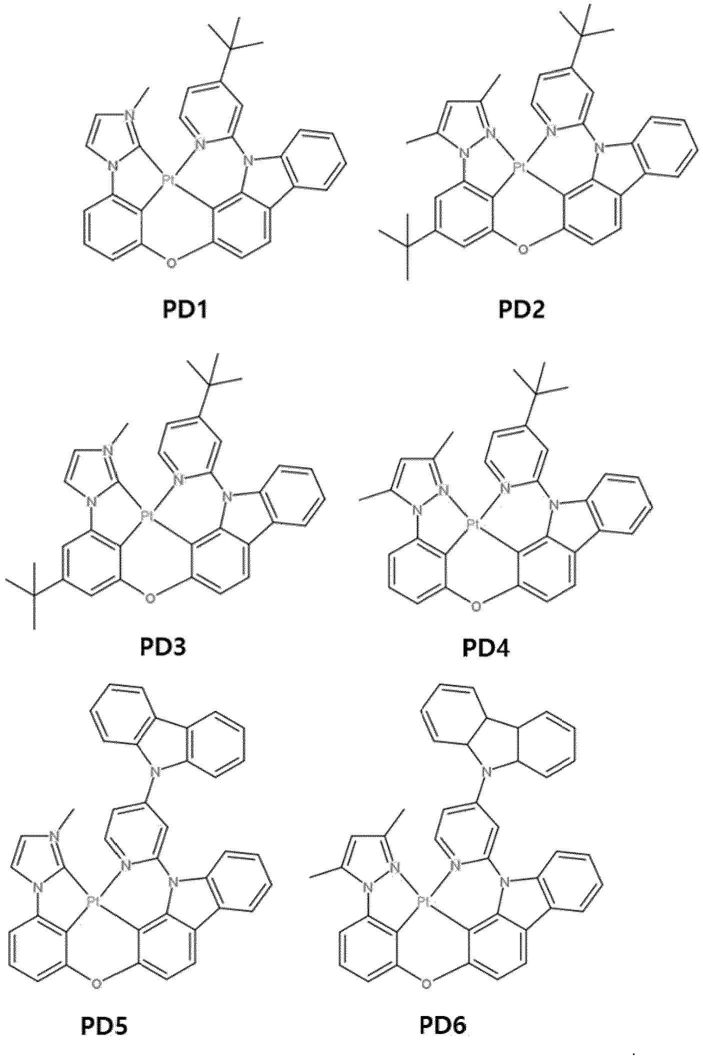

9. The organic light emitting diode according to any of claims 6-8, wherein the second compound is represented by Formula 3: 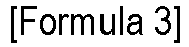 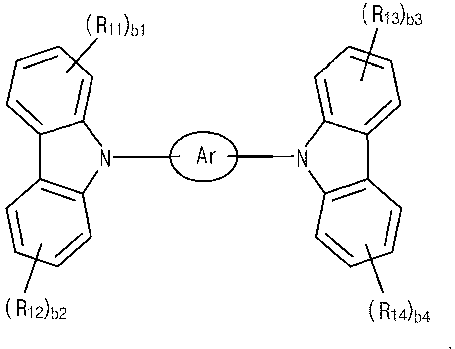
wherein Ar is selected from the group consisting of a substituted or unsubstituted C6 to C30 arylene group and a substituted or unsubstituted C5 to C30 heteroarylene group,
wherein each of R₁₁, R₁₂, R₁₃ and R₁₄ is independently selected from the group consisting of a substituted or unsubstituted C1 to C10 alkyl group and a substituted or unsubstituted C6 to C30 aryl group, and each of b1, b2, b3 and b4 is independently an integer of 0 to 4, and/or
wherein the third compound is represented by Formula 5: 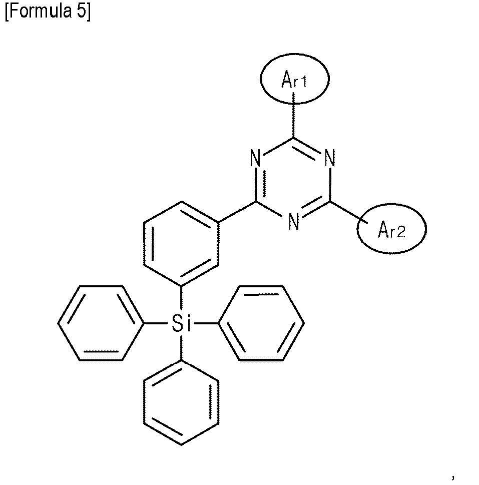
wherein each of Ar₁ and Ar₂ is independently selected from the group consisting of a substituted or unsubstituted C6 to C30 aryl group and a substituted or unsubstituted C5 to C30 heteroaryl group.

10. The organic light emitting diode according to claim 9, wherein the second compound is one of compounds in Formula 4: 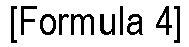 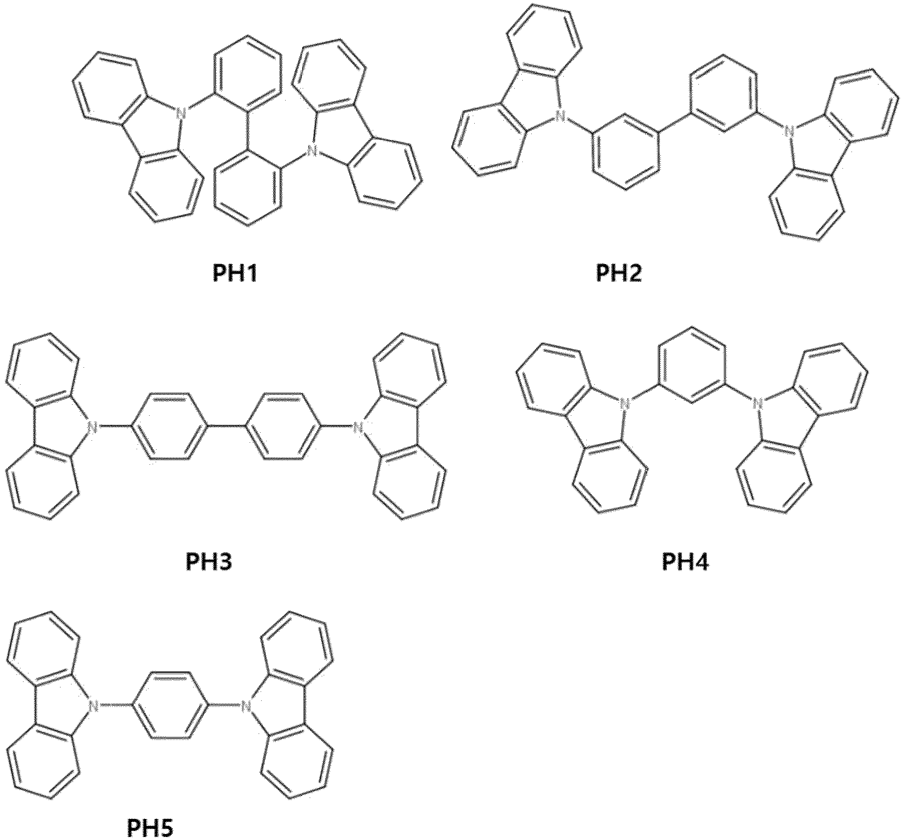 ; and/or
wherein the third compound is one of compounds in Formula 6:

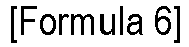

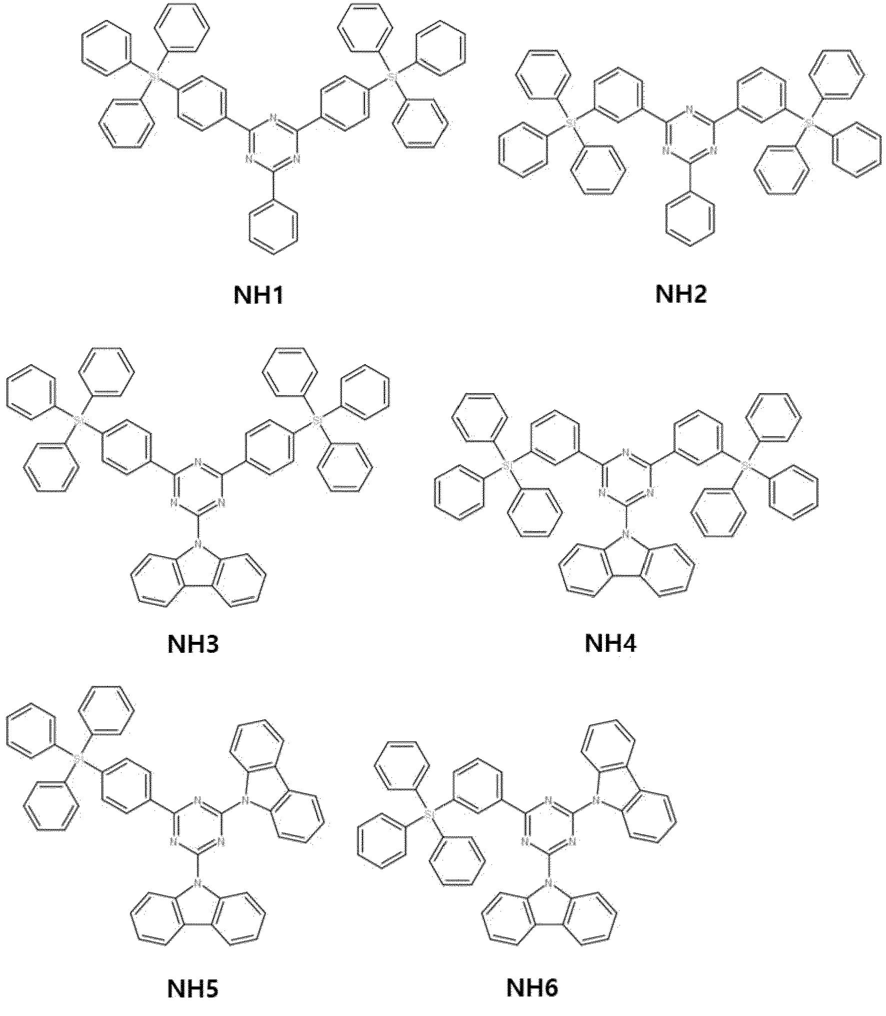

11. The organic light emitting diode according to any of preceding claim, wherein the first blue emitting material layer includes the fourth compound and a fifth compound,
wherein the fourth compound is represented by Formula 7: 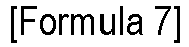 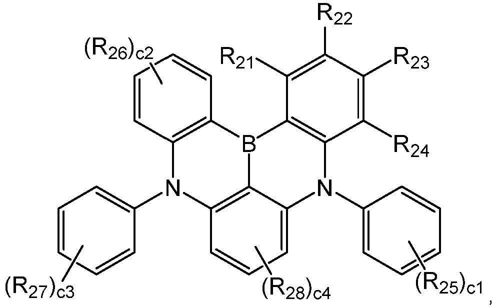
wherein each of R₂₁, R₂₂, R₂₃ and R₂₄ is independently selected from the group consisting of hydrogen, a substituted or unsubstituted **C1** to C10 alkyl group, a substituted or unsubstituted C6 to C30 aryl group, a substituted or unsubstituted C5 to C30 heteroaryl group and a substituted or unsubstituted C6 to C30 arylamine group, or
any adjacent two R₂₁, R₂₂, R₂₃ and R₂₄ are connected to each other, together with the atoms to which they are attached, to form a 6 to 30 membered fused ring having ring boron and nitrogen atoms, optionally further substituted with one or substituents selected from the group consisting of a substituted or unsubstituted C6 to C30 aryl group and a substituted or unsubstituted C6 to C30 arylamine group,
wherein each of R₂₅, R₂₆, R₂₇ and R₂₈ is independently selected from the group consisting of a substituted or unsubstituted **C1** to C10 alkyl group, a substituted or unsubstituted C6 to C30 aryl group, a substituted or unsubstituted C5 to C30 heteroaryl group and a substituted or unsubstituted C6 to C30 arylamine group;
each of c1 and c3 is independently an integer of 0 to 5, c2 is an integer of 0 to 4, and c4 is an integer of 0 to 3, and/or wherein the fifth compounds is represented by Formula 9: 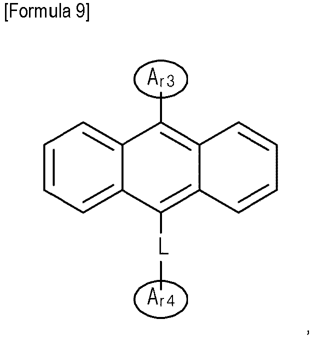
wherein each of Ar₃ and Ar₄ is independently selected from the group consisting of a substituted or unsubstituted C6 to C30 aryl group and a substituted or unsubstituted C5 to C30 heteroaryl group, and L is a single bond or a C6 to C30 arylene group.

12. The organic light emitting diode according to claim 11, wherein the fourth compound is one of compounds in Formula 8: 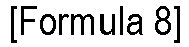 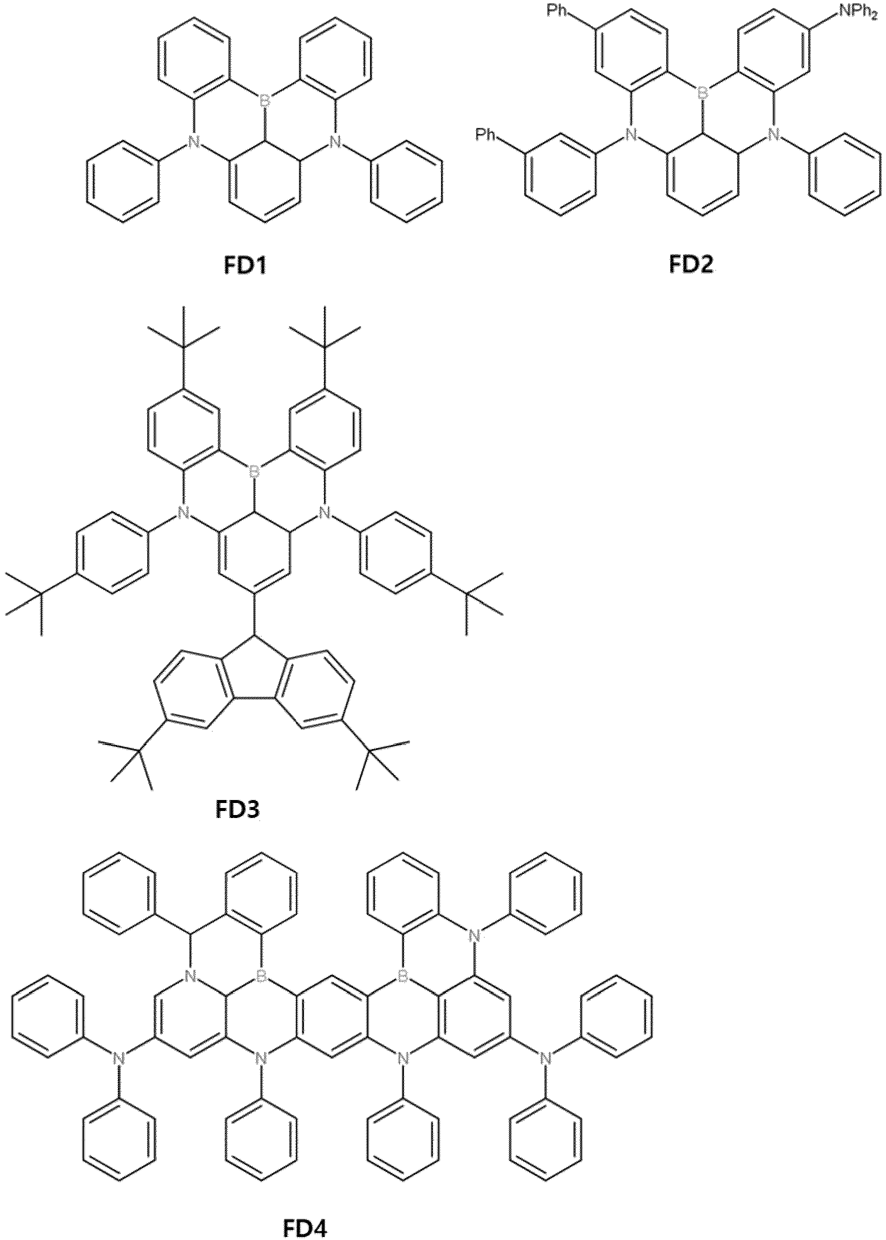 ; and/or
wherein the fifth compound is one of compounds in Formula 10:

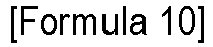

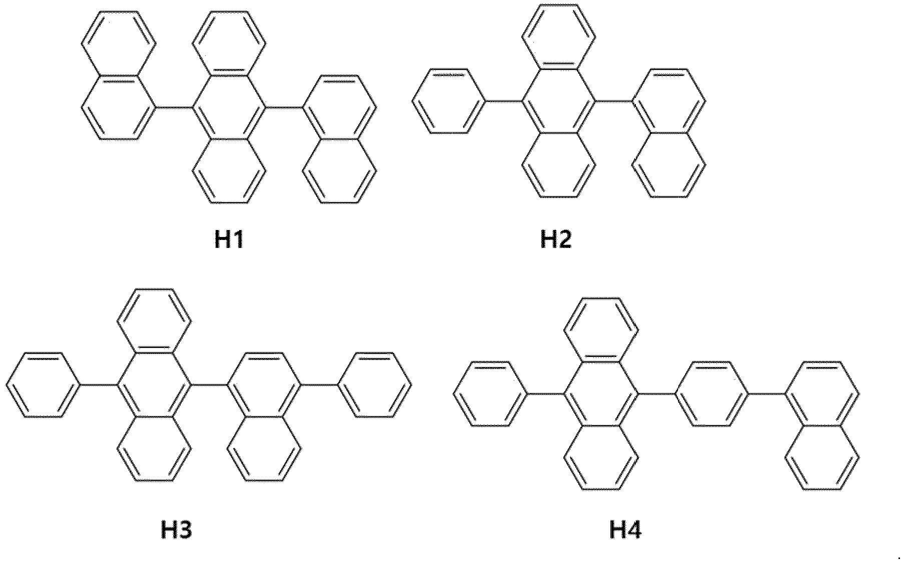

13. An organic light emitting display device (100), comprising:
a substrate (110); and
an organic light emitting diode according to any preceding claim disposed on or over the substrate.

14. The organic light emitting display device according to claim 13, wherein:
a) the substrate includes a red pixel region, a green pixel region and a blue pixel region, and the organic light emitting diode is positioned in the blue pixel region; or
b) the substrate includes a red pixel region, a green pixel region and a blue pixel region,
wherein the organic light emitting diode further includes a third emitting part including a third emitting material layer and positioned between the first and second emitting parts, and the third emitting material layer emits red and green light, and
wherein the organic light emitting diode is positioned in the red, green and blue pixel regions; optionally further comprising:
a color filter layer between the substrate and the organic light emitting diode or over the organic light emitting diode; or
c) the substrate includes a red pixel region, a green pixel region and a blue pixel region, and the organic light emitting diode is positioned in the red, green and blue pixel regions, and
wherein the organic light emitting display device further comprises: a color conversion layer disposed between the substrate and the organic light emitting diode or over the organic light emitting diode and corresponding to the red and green pixel regions.

15. The organic light emitting display device according to claim 13 or 14, wherein the first blue emitting material layer has a first thickness, and the second blue emitting material layer has a second thickness greater than the first thickness, and
wherein a ratio of the first thickness to the second thickness is 0.6 or less.

## Patentansprüche

1. Organische Leuchtdiode, die Folgendes umfasst:
eine reflektierende Elektrode (210);
eine transparente Elektrode (230), die der reflektierenden Elektrode (210) zugewandt ist;
einen ersten Emissionsteil (310), der eine erste Blauemissionsmaterialschicht (320) beinhaltet und zwischen der reflektierenden Elektrode (210) und der transparenten Elektrode (230) positioniert ist, wobei die erste Blauemissionsmaterialschicht (320) eine fluoreszierende Emissionsschicht ist, die eine vierte Verbindung als einen fluoreszierenden Dotierungsstoff umfasst; und
einen zweiten Emissionsteil (350), der eine zweite Blauemissionsmaterialschicht (360) beinhaltet und zwischen dem ersten Emissionsteil (310) und der transparenten Elektrode (230) positioniert ist, wobei die zweite Blauemissionsmaterialschicht (360) eine phosphoreszierende Emissionsschicht ist, die eine erste Verbindung als einen phosphoreszierenden Dotierungsstoff umfasst,
**dadurch gekennzeichnet, dass**
ein Verhältnis einer Intensität einer zweiten Emissionsspitze der ersten phosphoreszierenden Dotierungsstoffverbindung in der zweiten Blauemissionsmaterialschicht (360) zu einer Intensität einer ersten Emissionsspitze der ersten phosphoreszierenden Dotierungsstoffverbindung in der zweiten Blauemissionsmaterialschicht (360) 0,5 oder weniger beträgt,
wobei die erste Emissionsspitze eine Spitze mit der größten Emissionsintensität bedeutet und die zweite Emissionsspitze eine Spitze mit der zweitgrößten Emissionsintensität bedeutet.

2. Organische Leuchtdiode nach Anspruch 1, wobei die erste Blauemissionsmaterialschicht eine erste Dicke aufweist und die zweite Blauemissionsmaterialschicht eine zweite Dicke aufweist, die größer als die erste Dicke ist.

3. Organische Leuchtdiode nach Anspruch 2, wobei ein Verhältnis der ersten Dicke zu der zweiten Dicke 0,6 oder weniger beträgt.

4. Organische Leuchtdiode nach Anspruch 3, wobei die erste Dicke 10 nm oder mehr beträgt und die zweite Dicke 50 nm oder weniger beträgt.

5. Organische Leuchtdiode nach Anspruch 1, wobei eine Differenz zwischen einer maximalen Emissionswellenlänge der vierten fluoreszierenden Dotierungsstoffverbindung der ersten Blauemissionsmaterialschicht und einer maximalen Emissionswellenlänge der ersten phosphoreszierenden Dotierungsstoffverbindung der zweiten Blauemissionsmaterialschicht 20 nm oder weniger beträgt

6. Organische Leuchtdiode nach einem vorhergehenden Anspruch, wobei die zweite Blauemissionsmaterialschicht ferner eine zweite Verbindung als einen ersten Wirt und eine dritte Verbindung als einen zweiten Wirt beinhaltet.

7. Organische Leuchtdiode nach Anspruch 6, wobei die erste Verbindung ein Platinkomplex ist, der durch Formel 1 repräsentiert wird: 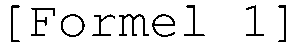 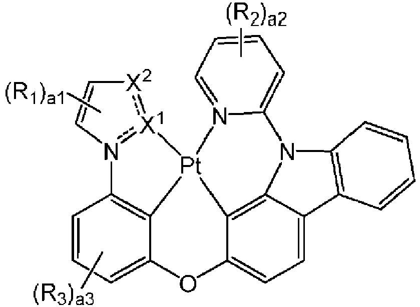
wobei R₁, R₂ und R₃ jeweils unabhängig aus der Gruppe ausgewählt werden, die aus einer substituierten oder nichtsubstituierten C1- bis C10-Alkylgruppe, einer substituierten oder nichtsubstituierten C6- bis C30-Arylgruppe und einer substituierten oder nichtsubstituierten C5- bis C30-Heteroarylgruppe besteht,
wobei a1 eine ganze Zahl von 0 bis 2 ist, a2 eine ganze Zahl von 0 bis 4 ist und a3 eine ganze Zahl von 0 bis 4 ist,
wobei X₁ C oder N ist und X₂ CR₄ oder NR₄ ist, und
wobei R₄ aus der Gruppe ausgewählt wird, die aus Wasserstoff, einer substituierten oder nichtsubstituierten C1- bis C10-Alkylgruppe, einer substituierten oder nichtsubstituierten C6- bis C30-Arylgruppe und einer substituierten oder nichtsubstituierten C5- bis C30-Heteroarylgruppe besteht.

8. Organische Leuchtdiode nach Anspruch 7, wobei die erste Verbindung eine von Verbindungen der Formel 2 ist:

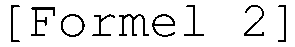

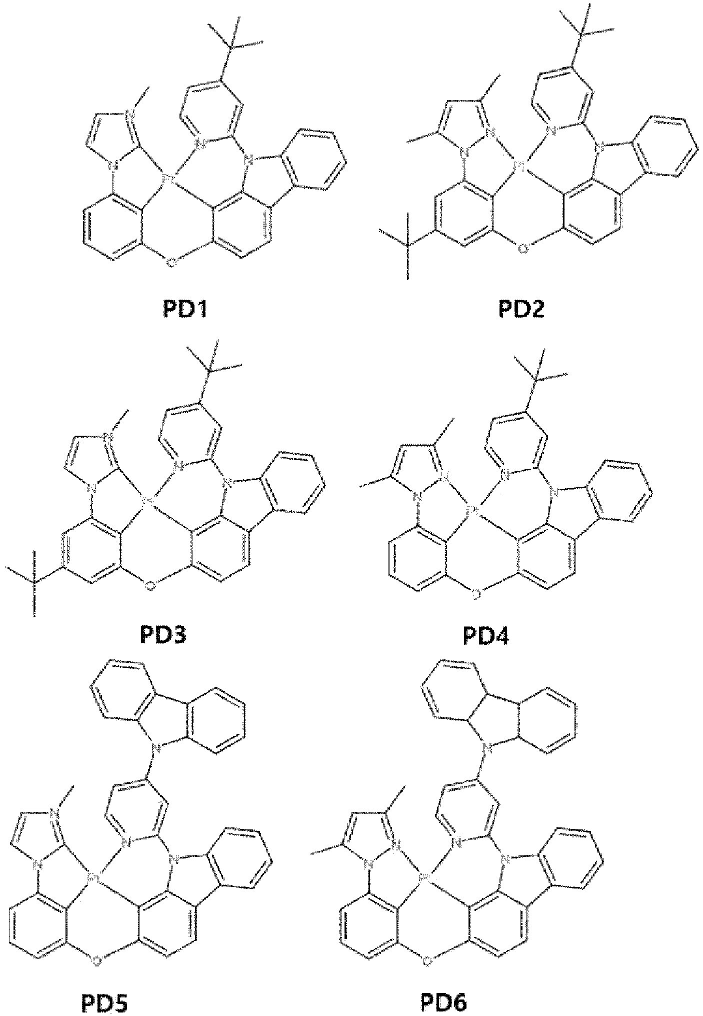

9. Organische Leuchtdiode nach einem der Ansprüche 6-8, wobei die zweite Verbindung durch Formel 3 repräsentiert wird: 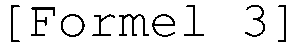 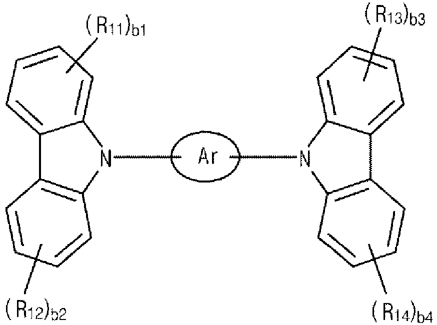
wobei Ar aus der Gruppe ausgewählt wird, die aus einer substituierten oder nichtsubstituierten C6- bis C30-Arylengruppe und einer substituierten oder nichtsubstituierten C5- bis C30-Heteroarylengruppe besteht,
wobei R₁₁, R₁₂, R₁₃ und R₁₄ jeweils unabhängig aus der Gruppe ausgewählt werden, die aus einer substituierten oder nichtsubstituierten C1- bis C10-Alkylgruppe und einer substituierten oder nichtsubstituierten C6- bis C30-Arylgruppe besteht, und b1, b2, b3 und b4 jeweils unabhängig eine ganze Zahl von 0 bis 4 sind, und/oder
wobei die dritte Verbindung durch Formel 5 repräsentiert wird: 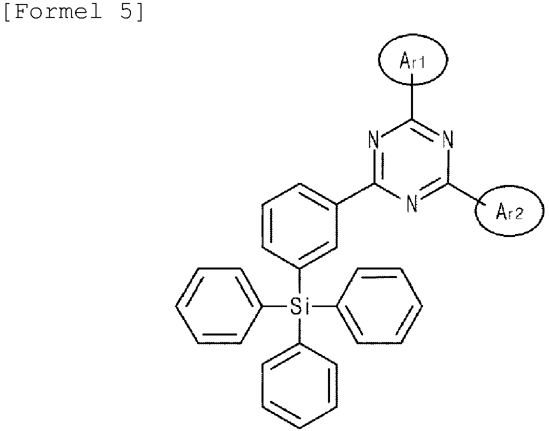
wobei Ar₁ und Ar₂ jeweils unabhängig aus der Gruppe ausgewählt werden, die aus einer substituierten oder nichtsubstituierten C6- bis C30-Arylgruppe und einer substituierten oder nichtsubstituierten C5- bis C30-Heteroarylgruppe besteht.

10. Organische Leuchtdiode nach Anspruch 9, wobei die zweite Verbindung eine der Verbindungen in Formel 4 ist: 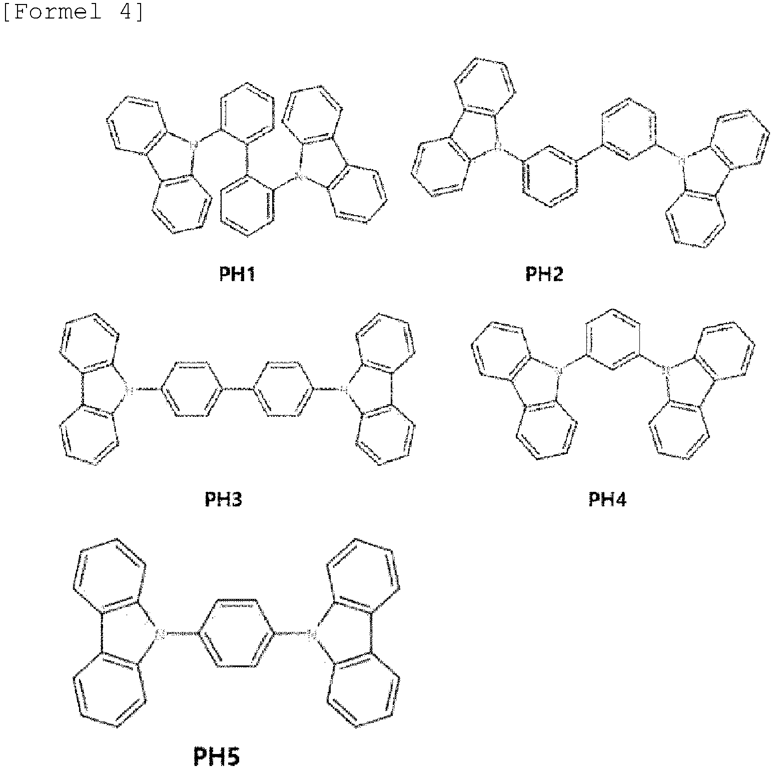 ; und/oder
wobei die dritte Verbindung eine der Verbindungen in Formel 6 ist:

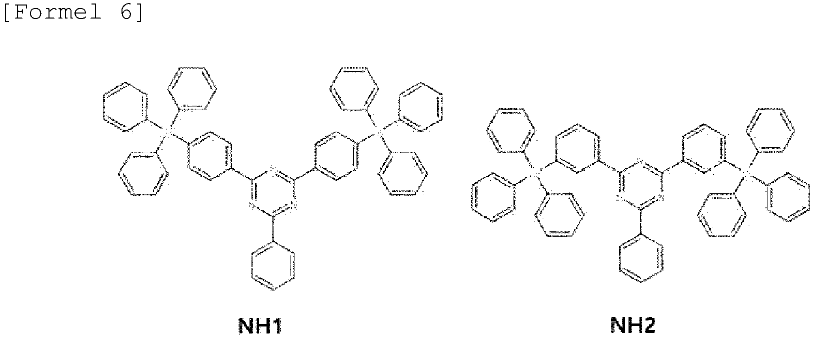

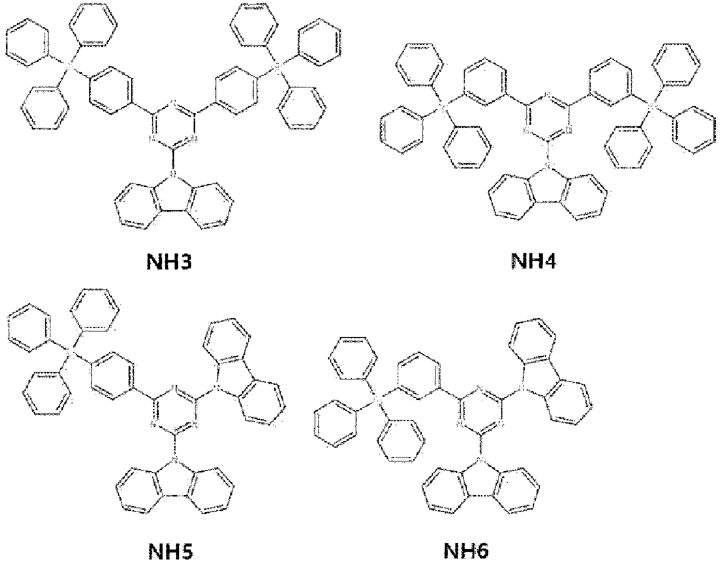

11. Organische Leuchtdiode nach einem vorhergehenden Anspruch, wobei die erste Blauemissionsmaterialschicht die vierte Verbindung und eine fünfte Verbindung beinhaltet,
wobei die vierte Verbindung durch Formel 7 repräsentiert wird: 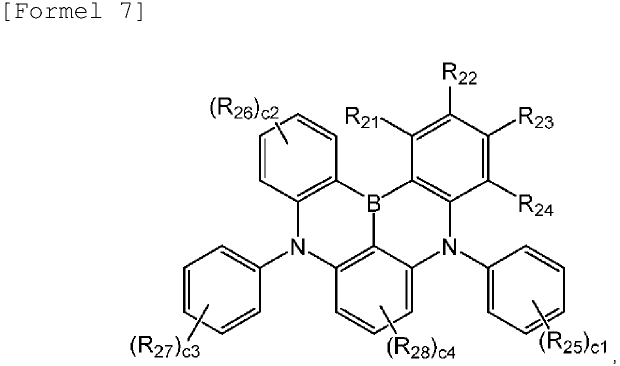
wobei R₂₁, R₂₂, R₂₃ und R₂₄ jeweils unabhängig aus der Gruppe ausgewählt werden, die aus Wasserstoff, einer substituierten oder nichtsubstituierten C1- bis C10-Alkylgruppe, einer substituierten oder nichtsubstituierten C6- bis C30-Arylgruppe, einer substituierten oder nichtsubstituierten C5- bis C30-Heteroarylgruppe und einer substituierten oder nichtsubstituierten C6- bis C30-Arylamingruppe besteht, oder
beliebige zwei benachbarte R₂₁, R₂₂, R₂₃ und R₂₄ miteinander verbunden sind, zusammen mit den Atomen, an die sie gebunden sind, um einen 6- bis 30-gliedrigen kondensierten Ring mit Ringboratomen und - stickstoffatomen zu bilden, optional ferner mit einem oder Substituenten substituiert, die aus der Gruppe ausgewählt sind, die aus einer substituierten oder nichtsubstituierten C6- bis C30-Arylgruppe und einer substituierten oder nichtsubstituierten C6- bis C30-Arylamingruppe besteht,
wobei R₂₅, R₂₆, R₂₇ und R₂₈ jeweils unabhängig aus der Gruppe ausgewählt werden, die aus einer substituierten oder nichtsubstituierten C1- bis C10-Alkylgruppe, einer substituierten oder nichtsubstituierten C6- bis C30-Arylgruppe, einer substituierten oder nichtsubstituierten C5- bis C30-Heteroarylgruppe und einer substituierten oder nichtsubstituierten C6- bis C30-Arylamingruppe besteht;
c1 und c3 jeweils unabhängig eine ganze Zahl von 0 bis 5 sind, c2 eine ganze Zahl von 0 bis 4 ist und c4 eine ganze Zahl von 0 bis 3 ist, und/oder
wobei die fünften Verbindungen durch Formel 9 repräsentiert werden: 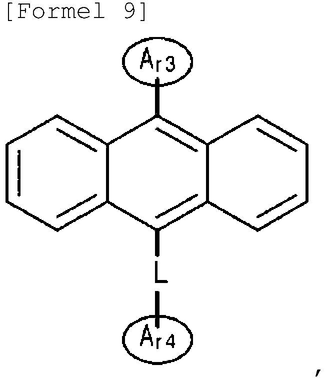
wobei Ar₃ und Ar₄ jeweils unabhängig aus der Gruppe ausgewählt werden, die aus einer substituierten oder nichtsubstituierten C6- bis C30-Arylgruppe und einer substituierten oder nichtsubstituierten C5- bis C30-Heteroarylgruppe besteht, und L eine Einfachbindung oder eine C6- bis C30-Arylengruppe ist.

12. Organische Leuchtdiode nach Anspruch 11, wobei die vierte Verbindung eine der Verbindungen in Formel 8 ist: 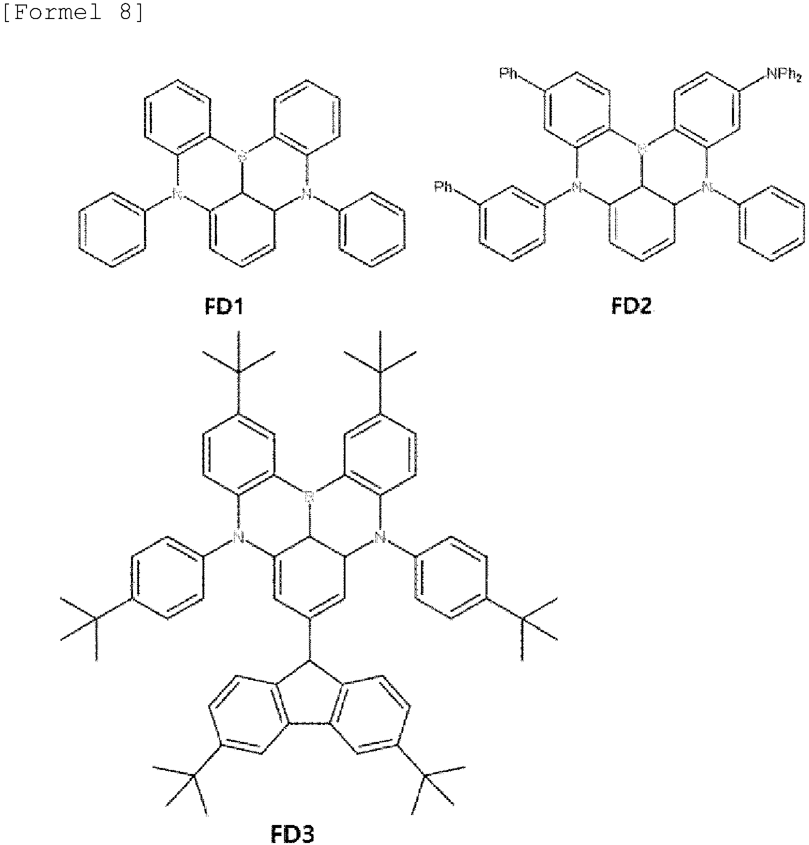 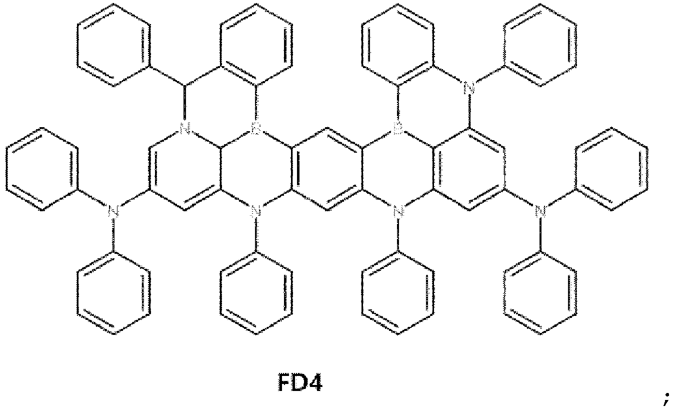 und/oder
wobei die fünfte Verbindung eine der Verbindungen in Formel 10 ist:

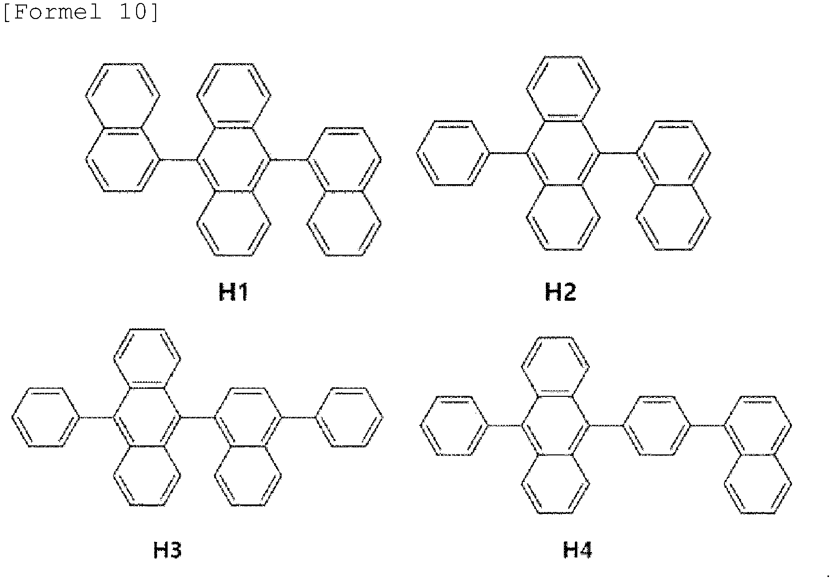

13. Organische lichtemittierende Anzeigevorrichtung (100), die Folgendes umfasst:
ein Substrat (110); und
eine organische Leuchtdiode nach einem vorhergehenden Anspruch, die auf oder über dem Substrat angeordnet ist.

14. Organische lichtemittierende Anzeigevorrichtung nach Anspruch 13, wobei:
a) das Substrat ein Rotpixelgebiet, ein Grünpixelgebiet und ein Blaupixelgebiet beinhaltet und die organische Leuchtdiode in dem Blaupixelgebiet positioniert ist; oder
b) das Substrat ein Rotpixelgebiet, ein Grünpixelgebiet und ein Blaupixelgebiet beinhaltet, wobei die organische Leuchtdiode ferner einen dritten Emissionsteil beinhaltet, der eine dritte Emissionsmaterialschicht beinhaltet und zwischen dem ersten und dem zweiten Emissionsteil positioniert ist, und die dritte Emissionsmaterialschicht rotes und grünes Licht emittiert, und
wobei die organische Leuchtdiode in de, Rot-, Grün- und Blaupixelgebiet positioniert ist; optional ferner umfassend:
eine Farbfilterschicht zwischen dem Substrat und der organischen Leuchtdiode oder über der organischen Leuchtdiode; oder
c) das Substrat ein Rotpixelgebiet, ein Grünpixelgebiet und ein Blaupixelgebiet beinhaltet und die organische Leuchtdiode in dem Rot-, Grün- und Blaupixelgebiet positioniert ist, und
wobei die organische lichtemittierende Anzeigevorrichtung ferner Folgendes umfasst: eine Farbumwandlungsschicht, die zwischen dem Substrat und der organischen Leuchtdiode oder über der organischen Leuchtdiode angeordnet ist und dem Rot- und Grünpixelgebiet entspricht.

15. Organische lichtemittierende Anzeigevorrichtung nach Anspruch 13 oder 14, wobei die erste Blauemissionsmaterialschicht eine erste Dicke aufweist und die zweite Blauemissionsmaterialschicht eine zweite Dicke aufweist, die größer als die erste Dicke ist, und wobei ein Verhältnis der ersten Dicke zu der zweiten Dicke 0,6 oder weniger beträgt.

## Revendications

1. Diode électroluminescente organique, comprenant :
une électrode réfléchissante (210) ;
une électrode transparente (230) en regard de l'électrode réfléchissante (210) ;
une première partie émettrice (310) comportant une première couche de matériau émettant dans le bleu (320) et positionnée entre l'électrode réfléchissante (210) et l'électrode transparente (230), la première couche de matériau émettant dans le bleu (320) étant une couche émettrice fluorescente comprenant un quatrième composé jouant le rôle de dopant fluorescent ; et
une deuxième partie émettrice (350) comportant une deuxième couche de matériau émettant dans le bleu (360) et positionnée entre la première partie émettrice (310) et l'électrode transparente (230), la deuxième couche de matériau émettant dans le bleu (360) étant une couche émettrice phosphorescente comprenant un premier composé jouant le rôle de dopant phosphorescent,
**caractérisée en ce que**
un rapport entre une intensité d'un deuxième pic d'émission du premier composé dopant phosphorescent dans la deuxième couche de matériau émettant dans le bleu (360) et une intensité d'un premier pic d'émission du premier composé dopant phosphorescent dans la deuxième couche de matériau émettant dans le bleu (360) est de 0,5 ou moins,
le premier pic d'émission signifiant un pic ayant la plus forte intensité d'émission, et le deuxième pic d'émission signifiant un pic ayant la deuxième plus forte intensité d'émission.

2. Diode électroluminescente organique selon la revendication 1, dans laquelle la première couche de matériau émettant dans le bleu a une première épaisseur, et la deuxième couche de matériau émettant dans le bleu a une deuxième épaisseur supérieure à la première épaisseur.

3. Diode électroluminescente organique selon la revendication 2, dans laquelle un rapport entre la première épaisseur et la deuxième épaisseur est de 0,6 ou moins.

4. Diode électroluminescente organique selon la revendication 3, dans laquelle la première épaisseur est de 10 nm ou plus, et la deuxième épaisseur est de 50 nm ou moins.

5. Diode électroluminescente organique selon la revendication 1, dans laquelle une différence entre une longueur d'onde d'émission maximale du quatrième composé dopant fluorescent de la première couche de matériau émettant dans le bleu et une longueur d'onde d'émission maximale du premier composé dopant phosphorescent de la deuxième couche de matériau émettant dans le bleu est de 20 nm ou moins.

6. Diode électroluminescente organique selon une quelconque revendication précédente, dans laquelle la deuxième couche de matériau émettant dans le bleu comporte en outre un deuxième composé jouant le rôle de premier hôte et un troisième composé jouant le rôle de deuxième hôte.

7. Diode électroluminescente organique selon la revendication 6, dans laquelle le premier composé est un complexe de platine représenté par la formule 1 : 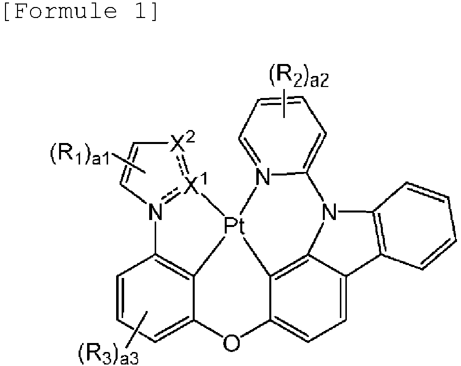
dans laquelle R₁, R₂ et R₃ sont chacun indépendamment choisis dans le groupe constitué par un groupe alkyle en C1 à C10 substitué ou non substitué, un groupe aryle en C6 à C30 substitué ou non substitué et un groupe hétéroaryle en C5 à C30 substitué ou non substitué,
dans laquelle a1 est un entier de 0 à 2, a2 est un entier de 0 à 4, et a3 est un entier de 0 à 4,
dans laquelle X₁ est C ou N, et X₂ est CR₄ ou NR₄, et
dans laquelle R₄ est choisi dans le groupe constitué par l'hydrogène, un groupe alkyle en C1 à C10 substitué ou non substitué, un groupe aryle en C6 à C30 substitué ou non substitué et un groupe hétéroaryle en C5 à C30 substitué ou non substitué.

8. Diode électroluminescente organique selon la revendication 7, dans laquelle le premier composé est un des composés de formule 2

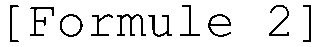

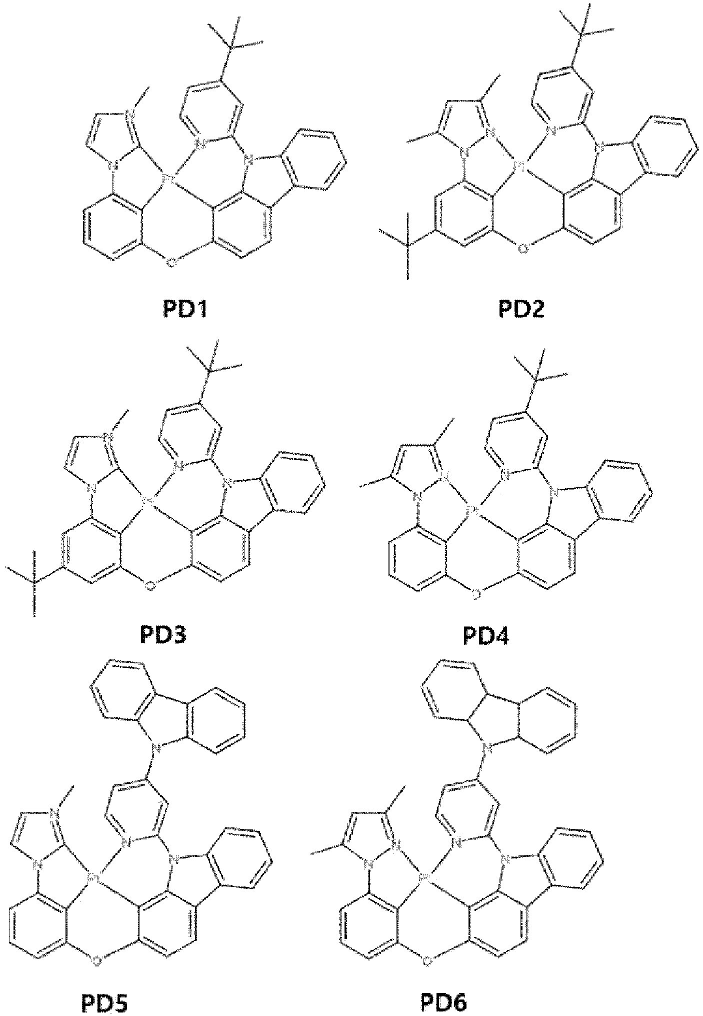

9. Diode électroluminescente organique selon l'une quelconque des revendications 6 à 8, dans laquelle le deuxième composé est représenté par la formule 3 : 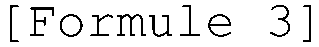 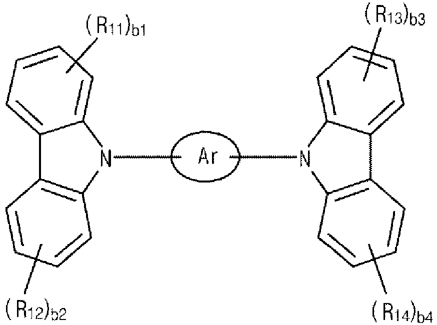
dans laquelle Ar est choisi dans le groupe constitué par un groupe arylène en C6 à C30 substitué ou non substitué et un groupe hétéroarylène en C5 à C30 substitué ou non substitué,
dans laquelle R₁₁, R₁₂, R₁₃ et R₁₄ sont chacun indépendamment choisis dans le groupe constitué par un groupe alkyle en C1 à C10 substitué ou non substitué et un groupe aryle en C6 à C30 substitué ou non substitué, et b1, b2, b3 et b4 sont chacun indépendamment un entier de 0 à 4, et/ou
dans laquelle le troisième composé est représenté par la formule 5 : 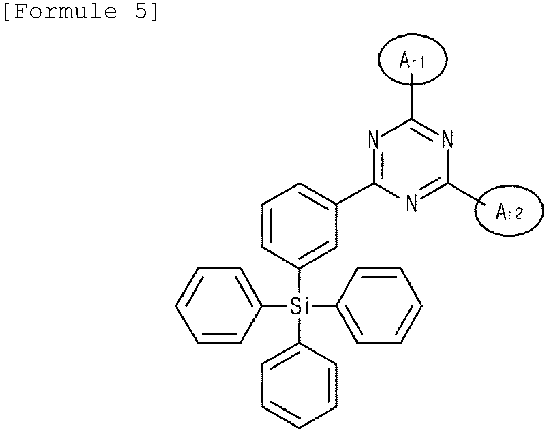
dans laquelle Ar₁ et Ar₂ sont chacun indépendamment choisis dans le groupe constitué par un groupe aryle en C6 à C30 substitué ou non substitué et un groupe hétéroaryle en C5 à C30 substitué ou non substitué.

10. Diode électroluminescente organique selon la revendication 9, dans laquelle le deuxième composé est un des composés de formule 4 : 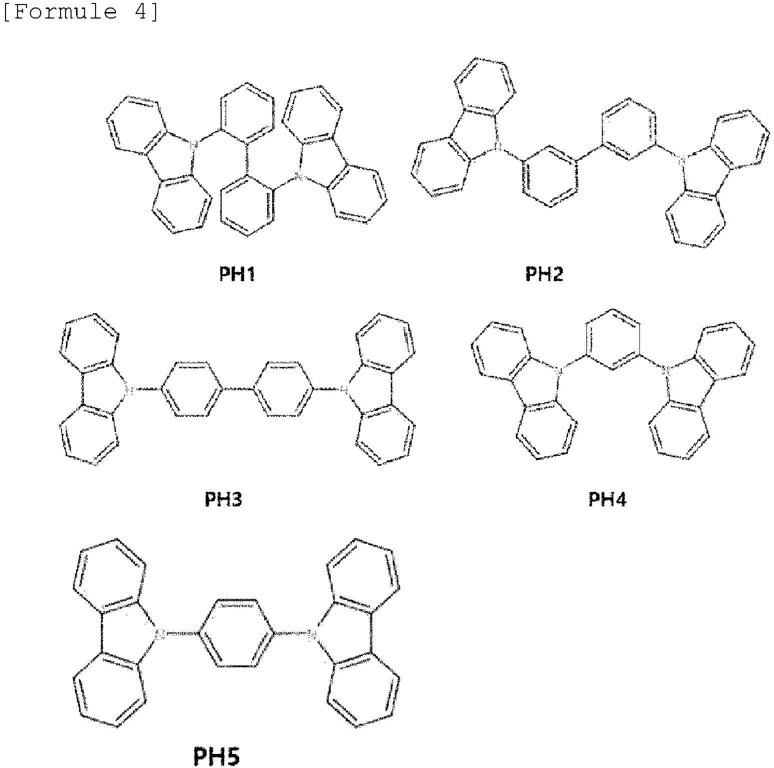 ; et/ou
dans laquelle le troisième composé est un des composés de formule 6 :

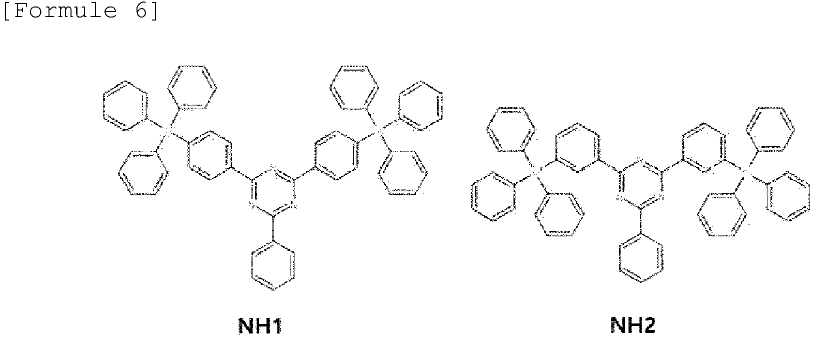

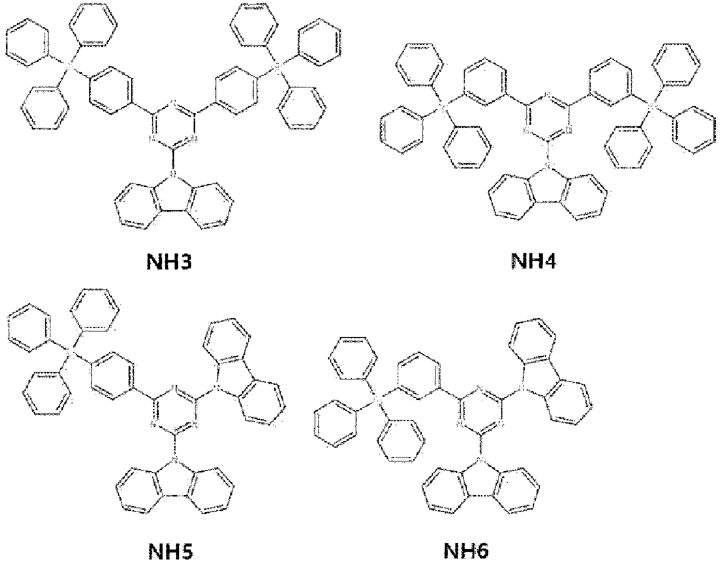

11. Diode électroluminescente organique selon l'une quelconque des revendications précédentes, dans laquelle la première couche de matériau émettant dans le bleu comporte le quatrième composé et un cinquième composé, dans laquelle le quatrième composé est représenté par la formule 7 : 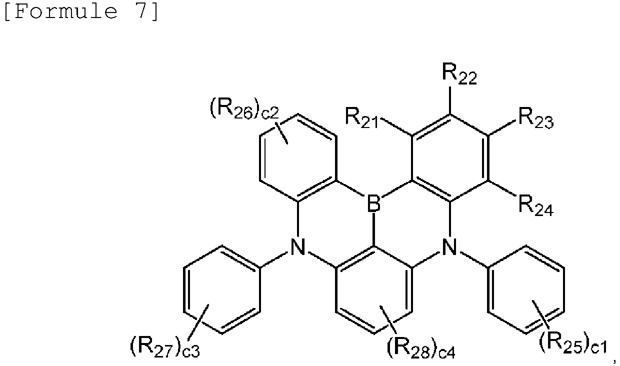
dans laquelle R₂₁, R₂₂, R₂₃ et R₂₄ sont chacun indépendamment choisis dans le groupe constitué par l'hydrogène, un groupe alkyle en C1 à C10 substitué ou non substitué, un groupe aryle en C6 à C30 substitué ou non substitué, un groupe hétéroaryle en C5 à C30 substitué ou non substitué et un groupe arylamine en C6 à C30 substitué ou non substitué, ou
deux radicaux adjacents quels qu'ils soient parmi R₂₁, R₂₂, R₂₃ et R₂₄ sont liés l'un à l'autre, conjointement avec les atomes auxquels ils sont attachés, pour former un cycle condensé à 6 à 30 chaînons portant des atomes de bore et d'azote cycliques, éventuellement substitué également par un ou des substituants choisis dans le groupe constitué par un groupe aryle en C6 à C30 substitué ou non substitué et un groupe arylamine en C6 à C30 substitué ou non substitué,
dans laquelle R₂₅, R₂₆, R₂₇ et R₂₈ sont chacun indépendamment choisis dans le groupe constitué par un groupe alkyle en C1 à C10 substitué ou non substitué, un groupe aryle en C6 à C30 substitué ou non substitué, un groupe hétéroaryle en C5 à C30 substitué ou non substitué et un groupe arylamine en C6 à C30 substitué ou non substitué ;
c1 et c3 sont chacun indépendamment un entier de 0 à 5, c2 est un entier de 0 à 4, et c4 est un entier de 0 à 3, et/ou
dans laquelle le cinquième composé est représenté par la formule 9 : 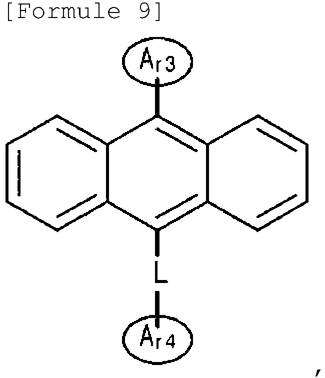
dans laquelle Ar₃ et Ar₄ sont chacun indépendamment choisis dans le groupe constitué par un groupe aryle en C6 à C30 substitué ou non substitué et un groupe hétéroaryle en C5 à C30 substitué ou non substitué, et L est une simple liaison ou un groupe arylène en C6 à C30.

12. Diode électroluminescente organique selon la revendication 11, dans laquelle le quatrième composé est un des composés de formule 8 : 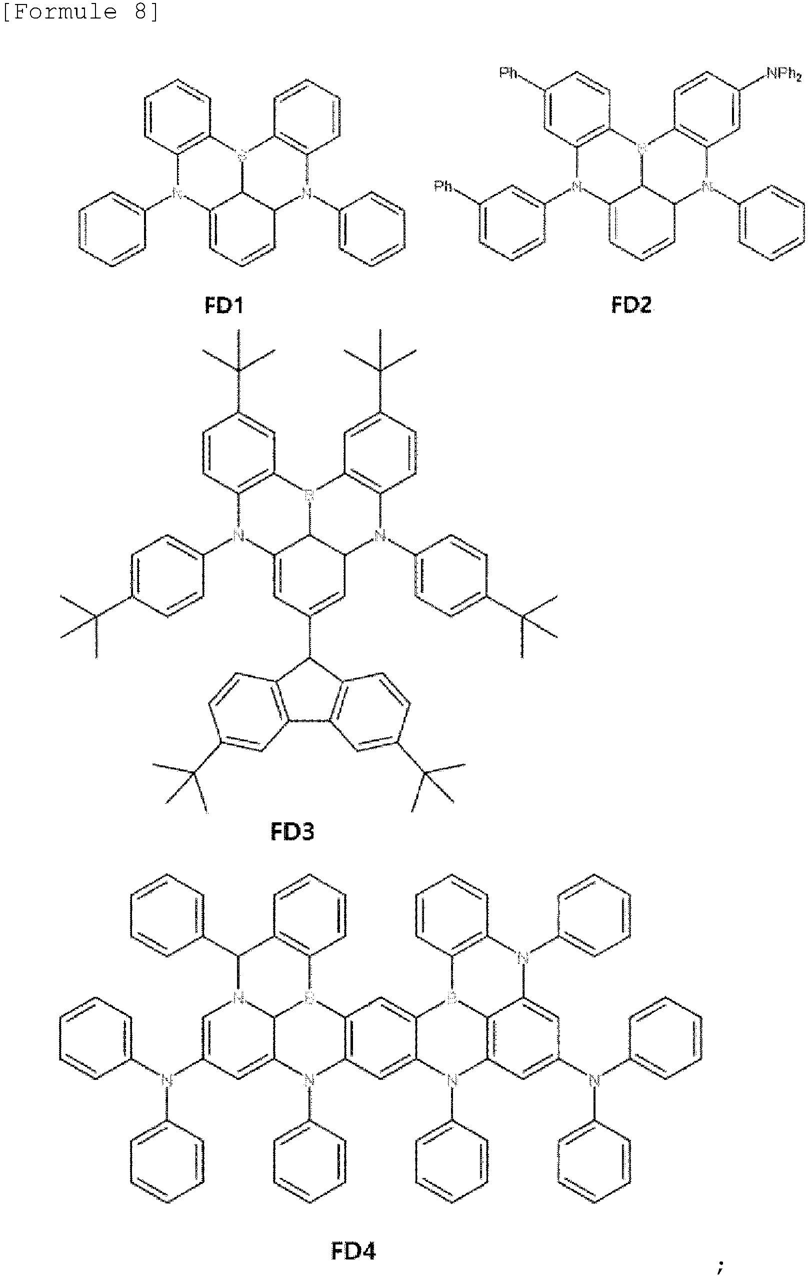 et/ou
dans laquelle le cinquième composé est un des composés de formule 10 :

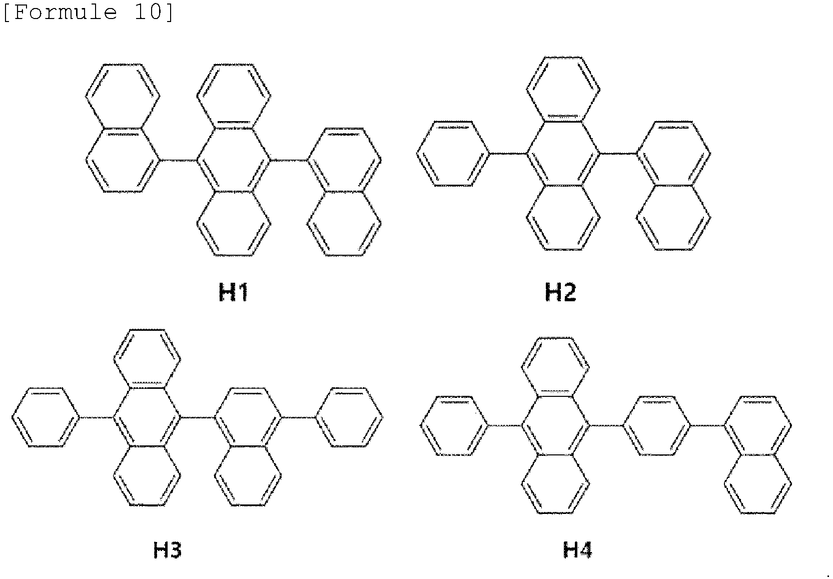

13. Dispositif d'affichage électroluminescent organique (100), comprenant :
un substrat (110) ; et
une diode électroluminescente organique selon une quelconque revendication précédente disposée sur ou au-dessus du substrat.

14. Dispositif d'affichage électroluminescent organique selon la revendication 13, dans lequel :
a) le substrat comporte une région de pixel rouge, une région de pixel vert et une région de pixel bleu, et la diode électroluminescente organique est positionnée dans la région de pixel bleu ; ou
b) le substrat comporte une région de pixel rouge, une région de pixel vert et une région de pixel bleu,
la diode électroluminescente organique comportant en outre une troisième partie émettrice comportant une troisième couche de matériau émetteur et positionnée entre les première et deuxième parties émettrices, et la troisième couche de matériau émetteur émettant de la lumière rouge et verte, et
la diode électroluminescente organique étant disposée dans les régions de pixel rouge, vert et bleu ; comprenant en outre éventuellement :
une couche de filtre coloré entre le substrat et la diode électroluminescente organique ou au-dessus de la diode électroluminescente organique ; ou
c) le substrat comporte une région de pixel rouge, une région de pixel vert et une région de pixel bleu, et la diode électroluminescente organique est positionnée dans les régions de pixel rouge, vert et bleu, et
le dispositif d'affichage électroluminescent organique comprenant en outre : une couche de conversion de couleur disposée entre le substrat et la diode électroluminescente organique ou au-dessus de la diode électroluminescente organique et correspondant aux régions de pixel rouge et vert.

15. Dispositif d'affichage électroluminescent organique selon la revendication 13 ou 14, dans lequel la première couche de matériau émettant dans le bleu a une première épaisseur, et la deuxième couche de matériau émettant dans le bleu a une deuxième épaisseur supérieure à la première épaisseur, et
dans lequel un rapport entre la première épaisseur et la deuxième épaisseur est de 0,6 ou moins.
